# EUROPEAN PATENT APPLICATION

(11) **EP 4 672 930 A1**
(43) Date of publication of application: **31.12.2025**
(21) Application number: 25184898.2
(22) Date of filing: 24.06.2025
(51) Int. Cl.: H10K 39/34, H10K 39/38, H10K 59/131, H10K 65/00, G09G 3/32

(54) **DISPLAY DEVICE AND ELECTRONIC DEVICE INCLUDING THE SAME**

(30) Priority: 25.06.2024 KR 20240082788
(71) Applicant: Samsung Display Co., Ltd., Yongin-si, Gyeonggi-do 17113 (KR)
(72) Inventor: YOON, So Il, 17113 Yongin-si (KR); SONG, Hee Rim, 17113 Yongin-si (KR); LEE, Kyung Hoe, 17113 Yongin-si (KR); LEE, Cheol Gon, 17113 Yongin-si (KR)
(74) Representative: Taor, Simon Edward William

(57) **Abstract**

A display device includes: a first subpixel, a second subpixel, and a third subpixel arranged in a first direction; a light-sensing pixel including a sensor circuit, and disposed between the second subpixel and the third subpixel; a readout line extending along a second direction, and electrically connected to the light-sensing pixel; a first data line extending along the second direction, and electrically connected to the second subpixel; a second data line extending along the second direction, and electrically connected to the third subpixel; a dummy pattern disposed between the first data line and the second data line; and a reset voltage wiring electrically connected to the light-sensing pixel and supplied with a reset voltage. The readout line may be disposed in a different layer from the first and second data lines. The readout line may be disposed in a same layer as the reset voltage wiring.

## Description

The application claims priority to Korean patent application number 10-2024-0082788, filed on 25 June, 2024.

### BACKGROUND

### 1. Field

Embodiments of the disclosure relate to a display device and an electronic device including the same.

### 2. Description of the Related Art

In recent, as interest in an information display increases, research and development on the display device are conducted continuously.

### SUMMARY

The disclosure may provide a display device with enhanced reliability and an electronic device including the same.

A display device in an embodiment of the disclosure includes: a first subpixel, a second subpixel, and a third subpixel arranged in a first direction; a light-sensing pixel including a sensor circuit, and disposed between the second subpixel and the third subpixel; a readout line extending along a second direction, and electrically connected to the light-sensing pixel; a first data line extending along the second direction, and electrically connected to the second subpixel; a second data line extending along the second direction, and electrically connected to the third subpixel; a dummy pattern disposed between the first data line and the second data line; and a reset voltage wiring electrically connected to the light-sensing pixel and supplied with a reset voltage. The readout line is disposed in a different layer from the first and second data lines. The readout line is disposed in a same layer as the reset voltage wiring.

In an embodiment, the dummy pattern may be disposed in a same layer as the first and second data lines. The dummy pattern, the first data line, and the second data line may be disposed on the readout line and the reset voltage wiring with an insulating layer interposed between a layer at which the dummy pattern, the first data line, and the second data line are located and a layer at which the readout line and the reset voltage wiring are located.

In an embodiment, the dummy pattern may overlap with the reset voltage wiring, and be electrically connected to the reset voltage wiring.

In an embodiment, the dummy pattern and the reset voltage wiring may be disposed between the first data line and the readout line, in a plan view.

In an embodiment, the sensor circuit may include a light-receiving element; a first sensor transistor for controlling current flowing to the readout line in response to a voltage of one electrode of the light-receiving element; a second sensor transistor electrically connected between the first sensor transistor and the readout line; and a third sensor transistor electrically connected between the reset voltage wiring and the one electrode of the light-receiving element and including a gate electrode connected to a reset line. The first and second sensor transistors may include a first type semiconductor. The third sensor transistor may include a second type semiconductor which is different from the first type semiconductor.

In an embodiment, the display device may further include a bridge pattern electrically connected a gate electrode of the first sensor transistor and the one electrode of the light-receiving element. The bridge pattern may be disposed in the same layer as the first and second data lines.

In an embodiment, the readout line may include a first part next to the bridge pattern in the first direction and a second part excluding the first part, in the plan view. The first part of the readout line may be disposed between the first data line and the bridge pattern, in the plan view. The second part of the readout line may be disposed between the first data line and the second data line, in the plan view.

In an embodiment, the dummy pattern may not overlap with the first part of the readout line.

In an embodiment, the dummy pattern may overlap with the second part of the readout line.

In an embodiment, the dummy pattern may not overlap with the first and second parts of the readout line.

In an embodiment, the readout line may be disposed between the reset voltage wiring and the second data line, in the plan view.

In an embodiment, the bridge pattern may be disposed between the first part of the readout line and the second data line, in the plan view.

In an embodiment, the dummy pattern may overlap with at least a part of the reset voltage wiring.

In an embodiment, the display device may include a substrate; first, second, third, fourth, fifth, sixth, seventh, eighth, and ninth insulating layers sequentially disposed on the substrate; a first conductive layer disposed between the substrate and the first insulating layer; a second conductive layer disposed between the second insulating layer and the third insulating layer; a third conductive layer disposed between the third insulating layer and the fourth insulating layer; a fourth conductive layer disposed between the fifth insulating layer and the sixth insulating layer; a fifth conductive layer disposed between the sixth insulating layer and the seventh insulating layer; a sixth conductive layer disposed between the seventh insulating layer and the eighth insulating layer; and a seventh conductive layer disposed between the eighth insulating layer and the ninth insulating layer. The sixth conductive layer may include the readout line and the reset voltage wiring. The seventh conductive layer may include the first data line, the second data line, and the dummy pattern.

In an embodiment, each of the first subpixel, the second subpixel, and the third subpixel may include a light-emitting element for emitting light and at least one transistor electrically connected to the light-emitting element.

A display device in an embodiment of the disclosure includes: a first subpixel, a second subpixel, and a third subpixel arranged in a first direction; a light-sensing pixel including a sensor circuit, and disposed between the second subpixel and the third subpixel; a readout line extending along a second direction, and electrically connected to the light-sensing pixel; a first data line extending along the second direction, and electrically connected to the second subpixel; a second data line extending along the second direction, and electrically connected to the third subpixel; a dummy pattern disposed between the first data line and the second data line; and a reset voltage wiring electrically connected to the light-sensing pixel and supplied with a reset voltage. The readout line and the reset voltage wiring may be disposed in a same layer. The first data line, the second data line, and the dummy pattern may be disposed in a same layer. The first data line, the second data line, and the dummy pattern may be disposed on the readout line and the reset voltage wiring with an insulating layer interposed between a layer at which the data line, the second data line and the dummy pattern are located and a layer at which the readout line and the reset voltage wiring are located. The reset voltage wiring may overlap with the dummy pattern, and be electrically connected to the dummy pattern to form a bi-layer structure with the dummy pattern.

In an embodiment, the reset voltage wiring and the dummy pattern overlapping each other may be disposed between the first data line and a part of the readout line, in a plan view.

In an embodiment, the display device may further include a bridge pattern electrically connected to a gate electrode of a first sensor transistor of the sensor circuit. The bridge pattern may be disposed in the same layer as the first data line, the second data line, and the dummy pattern. The readout line may include a first part next (adjacent) to the bridge pattern in the first direction and a second part excluding the first part, in a plan view. The dummy pattern may not overlap with the first part of the readout line, and may overlap with the second part of the readout line.

In an embodiment, an electronic device in an embodiment of the disclosure may include a processor for providing input image data to a display device; and the display device for displaying an image based on the input image data. The display device may include a first subpixel, a second subpixel, and a third subpixel arranged in a first direction; a light-sensing pixel including a sensor circuit, and disposed between the second subpixel and the third subpixel; a readout line extending along a second direction, and electrically connected to the light-sensing pixel; a first data line extending along the second direction, and electrically connected to the second subpixel; a second data line extending along the second direction, and electrically connected to the third subpixel; a dummy pattern disposed between the first data line and the second data line; and a reset voltage wiring electrically connected to the light-sensing pixel and supplied with a reset voltage. The readout line and the reset voltage wiring may be disposed in a same layer. The first data line, the second data line, and the dummy pattern may be disposed in a same layer. The first data line, the second data line, and the dummy pattern may be disposed on the readout line and the reset voltage wiring with an insulating layer interposed between a layer at which the first data line, the second data line, and the dummy pattern are located and a layer at which the readout line and the reset voltage wiring are located.

According to an aspect, there is provided a display device as set out in claim 1. Additional features are set out in claims 2 to 11. According to an aspect, there is provided a display device as set out in claim 12. Additional features are set out in claims 13 or 14. According to an aspect, there is provided an electronic device as set out in claim 15.

In an embodiment, the reset voltage wiring may overlap with the dummy pattern, and be electrically connected to the dummy pattern to form a bi-layer structure with the dummy pattern.

In embodiments, by arranging a data line and a readout line in different layers and arranging a bridge pattern electrically connected to a gate electrode of a first sensor transistor between the data line and the readout line, a separation distance between the data line and the readout line may be further obtained.

In embodiments, by arranging a dummy pattern formed in the same layer as a data line on a readout line and applied with a voltage having a constant voltage level, it is possible to provide a display device with enhanced reliability and an electronic device including the same by reducing or preventing a coupling cap which may occur between the data line and the readout line.

Effects according to the disclosure are not limited to the above, and more various effects are included in the specification.

### BRIEF DESCRIPTION OF THE DRAWINGS

The above and other embodiments, advantages and features of this disclosure will become more apparent by describing in further detail embodiments thereof with reference to the accompanying drawings, in which:
FIG. 1 is a schematic block diagram illustrating an embodiment of a display device.
FIG. 2 is a schematic block diagram illustrating an embodiment of a display device of FIG. 1.
FIG. 3 is a schematic diagram illustrating an embodiment of arrangement of pixel circuits and sensor circuits in a display area of a display panel included in a display device of FIG. 2.
FIG. 4 is a schematic diagram illustrating an embodiment of a display area of a display panel included in a display device of FIG. 2.
FIG. 5 is a schematic diagram illustrating an embodiment of a subpixel and a light-sensing pixel included in a display area of FIG. 1.
FIG. 6 is a schematic cross-sectional diagram illustrating an embodiment of one area of a display device.
FIG. 7 is a schematic cross-sectional diagram illustrating a reflection path of light in a display device of FIG. 6.
FIG. 8 is a schematic plan view illustrating an embodiment of a subpixel.
FIG. 9 is a schematic plan view illustrating an embodiment of subpixels and a first light-sensing pixel.
FIG. 10 is a schematic plan view illustrating only configurations included in a first conductive layer in FIGS. 8 and 9.
FIG. 11 is a schematic plan view illustrating only configurations included in a first semiconductor layer and a second conductive layer in FIGS. 8 and 9.
FIG. 12 is a schematic plan view illustrating only configurations included in a third conductive layer in FIGS. 8 and 9.
FIG. 13 is a schematic plan view illustrating only configurations included in a second semiconductor layer and a fourth conductive layer in FIGS. 8 and 9.
FIG. 14 is a schematic plan view illustrating only configurations included in a fifth conductive layer in FIG. 9.
FIG. 15 is a schematic plan view illustrating only configurations included in a sixth conductive layer in FIG. 9.
FIG. 16 is a schematic plan view illustrating only configurations included in a seventh conductive layer in FIG. 9.
FIG. 17 is a schematic plan view illustrating only configurations included in a fifth conductive layer, a sixth conductive layer, and a seventh conductive layer in FIG. 9.
FIG. 18 is a schematic cross-sectional diagram along line I-I' of FIG. 17.
FIG. 19 is a schematic plan view illustrating an embodiment of subpixels and a first light-sensing pixel disposed in one area of a display area of a display device.
FIG. 20 is a schematic plan view illustrating an embodiment of subpixels and a first light-sensing pixel disposed in one area of a display area of a display device.
FIG. 21 is a schematic plan view illustrating an embodiment of subpixels and a first light-sensing pixel disposed in one area of a display area of a display device.
FIG. 22 is a schematic cross-sectional diagram along line II-II' of FIG. 21.
FIG. 23 is a schematic block diagram illustrating an embodiment of an electronic device.
FIG. 24 is a schematic diagram illustrating an embodiment of an electronic device of FIG. 23 implemented with a smartphone.
FIG. 25 is a schematic diagram illustrating an embodiment of an electronic device of FIG. 23 implemented with a tablet personal computer ("PC").

### DETAILED DESCRIPTION

The disclosure may make various modifications and have various forms, and illustrative embodiments are to be illustrated in the drawings and elucidated herein. However, it is not intended to limit the disclosure to a particular disclosed form, and should be understood to include all modifications, equivalents or alternatives falling within the technical scope of the disclosure.

In describing each drawing, similar reference numerals are used for similar components. In the accompanying drawings, dimensions of structures are exaggerated for clarity of the disclosure. Terms such as first and second may be used to describe various components, but the components should not be limited by the above terms. The above terms are used only to distinguish one component from another component. For example, a first component may be referred to as a second component, and similarly, a second component may be referred to as a first component, without departing from the scope of the disclosure.

In the disclosure, it is to be understood that a term such as "comprising", "including" or "having" is intended to indicate existence of a feature, a number, a step, an operation, a component, a part, or a combination thereof disclosed in the specification, and is not intended to preclude a possibility that one or more other features, numbers, steps, operations, components, parts, or combinations thereof may exist or may be added. In addition, if a part such as a layer, a film, an area, or a plate is disposed "on" another part, this includes not only a case where the part is disposed "directly on" the other part but also a case where still another part is interposed therebetween. Also, if a part such as a layer, a film, an area, or a plate is formed on another part, the formed direction is not limited to an upper direction but includes a lateral or lower direction. By contrary, if a part such as a layer, a film, an area, or a plate is disposed "below" another part, this indicates not only a case where the part is disposed "directly below" the other part but also a case where still another part is interposed therebetween.

Hereafter, desired embodiments of the disclosure and other matters desired for those skilled in the art to easily understand contents of the disclosure will be described in detail with reference to the accompanying drawings. In the description below, singular expression include plural expression unless the context clearly includes only the singular.

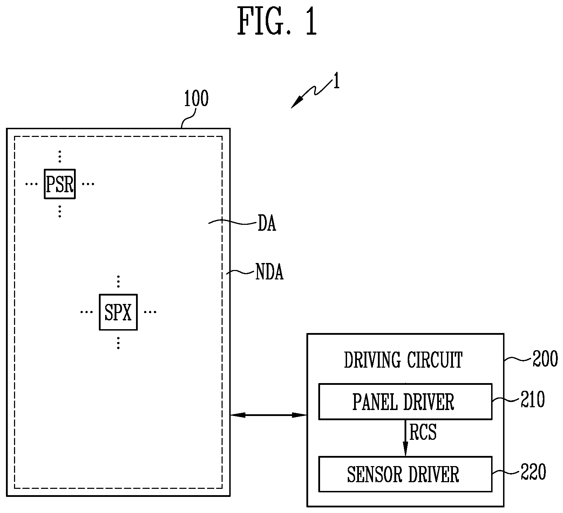

FIG. 1 is a schematic block diagram illustrating an embodiment of a display device 1.

Referring to FIG. 1, the display device 1 in embodiments may include a display panel 100 and a driving circuit 200. In embodiments, the driving circuit 200 may include a panel driver 210 and a sensor driver 220.

The display device 1 may be implemented as a self-emitting display device including a plurality of self-emitting elements. In an embodiment, the display device 1 may be an organic light-emitting display device including an organic light-emitting element, for example. However, embodiments are not limited thereto, and the display device 1 may be implemented as a display device including an inorganic light-emitting element, or, a display device including light-emitting element including or consisting of an inorganic material and an organic material in combination, a display device for displaying an image with quantum dots and so on.

The display device 1 may be a flat display device, a flexible display device, a curved display device, a foldable display device, a bendable display device, and a rollable display device. The display device 1 may be applied to a transparent display device, a head-mounted display device, a wearable display device, and so on.

The display panel 100 may include a display area DA and a non-display area NDA. The display area DA may be the area where subpixels SPX (or pixels) are provided. The subpixel SPX may include at least one light-emitting element. In an embodiment, a light-emitting element may include a light-emitting layer (e.g., an organic light-emitting layer), for example. A part radiated by the light-emitting element may be defined as a light-emitting area. The display device 1 may display an image in the display area DA by driving the subpixel SPX in response to image data.

The non-display area NDA may be an area provided in vicinity of the display area DA. In embodiments, the non-display area NDA may comprehensively indicate other area than the display area DA on the display panel 100. In an embodiment, the non-display area NDA may include a wiring area, a pad area, various dummy areas and so on, for example.

The display area DA may include a light-sensing pixel PSR. The light-sensing pixel PSR may be also referred to as an optical sensor. The light-sensing pixel PSR may include a light-receiving element which includes a light-receiving layer. Within the display area DA, the light-receiving layer of the light-receiving element may be disposed apart from the light-receiving layer of the light-emitting element.

Across the entirety of the area of the display area DA, a plurality of light-sensing pixels PSR may be distributed apart from each other. However, embodiments are not limited thereto, and only one area of the display area DA may be set as a predetermined sensing area, and light-sensing pixels PSR may be provided in a corresponding sensing area. Light-sensing pixels PSR may be provided in at least a part of the non-display area NDA.

The light-sensing pixel PSR may detect light emitted from a light source (e.g., a light-emitting element of the subpixel SPX) and reflected by an external object (e.g., a user's finger, etc.). In an embodiment, a user's fingerprint may be detected through the light-sensing pixel PSR, for example. Hereafter, it is described that the light-sensing pixel PSR is used for fingerprint detection as one of the embodiments, but the light-sensing pixel PSR may detect various biometric information such as iris and veins in various embodiments.

The driving circuit 200 may include the panel driver 210 and the sensor driver 220. The panel driver 210 and the sensor drive 220 may be implemented as independent integrated circuits. In embodiments, the driving circuit 200 may be implemented as an integrated circuit. In this case, at least a part of the sensor driver 220 may be included in the panel driver 210, or may operate in conjunction with the panel driver 210.

The panel driver 210 may scan the subpixel SPX of the display area DA, and supply a data signal corresponding to image data (or an image) to the subpixel SPX. The display panel 100 may display the image corresponding to the data signal.

The panel driver 210 may supply a driving signal for light sensing (e.g., fingerprint sensing) to the subpixel SPX. This driving signal may be provided for the subpixel SPX to emit light and operate as the light source for the light-sensing pixel PSR. The panel driver 210 may also supply the driving signal for the light sensing and/or other driving signal to the light-sensing pixel PSR. However, embodiments are not limited thereto, and the driving signals for the light sensing may be supplied to the light-sensing pixel PSR by the sensor driver 220.

The sensor driver 220 may detect biometric information such as a user's fingerprint based on a sensing signal received from the light-sensing pixel PSR. In embodiments, the sensor driver 220 may supply the driving signals to the light-sensing pixel PSR and/or the subpixel SPX.

The panel driver 210 may provide a readout control signal RCS to the sensor driver 220, and the sensor driver 220 may read out (or sample) the sensing signal in conjunction with the panel driver 210 based on the readout control signal RCS. In an embodiment, the sensor driver 220 may read out or sample the sensing signal in response to the readout control signal RCS, based on at least one pixel row (or, horizontal line), for example.

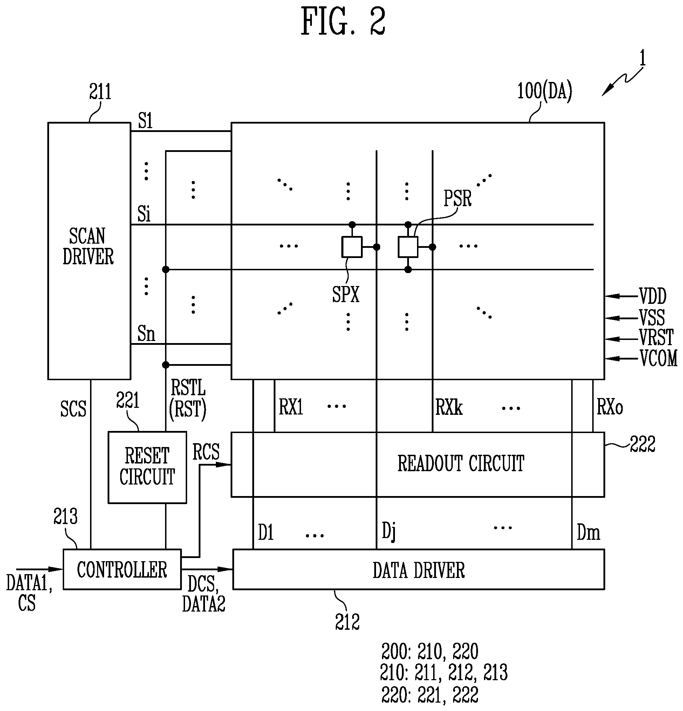

FIG. 2 is a schematic block diagram illustrating an embodiment of a display device 1 of FIG. 1.

Referring to FIG. 1 and FIG. 2, the display device 1 may include the display panel 100 and the driver 200.

The display panel 100 may include signal wiring, subpixels SPX, and light-sensing pixels PSR. The signal wiring may include scan lines S1 through Sn, data lines D1 through Dm, readout lines RX1 through RXo, and reset lines RSTL (or reset control lines). Herein, n, m, and o each may be a natural number greater than 1.

The subpixel SPX may be disposed or arranged in an area (e.g., a pixel area) divided by the scan lines S1 through Sn and the data lines D1 through Dm. The light-sensing pixel PSR may be disposed or arranged in an area divided by the scan lines S1 through Sn and the readout lines RX1 through RXo. The subpixel SPX and the light-sensing pixel PSR may be arranged in a two-dimensional array in the display area DA of the display panel 100, but embodiments are not limited thereto.

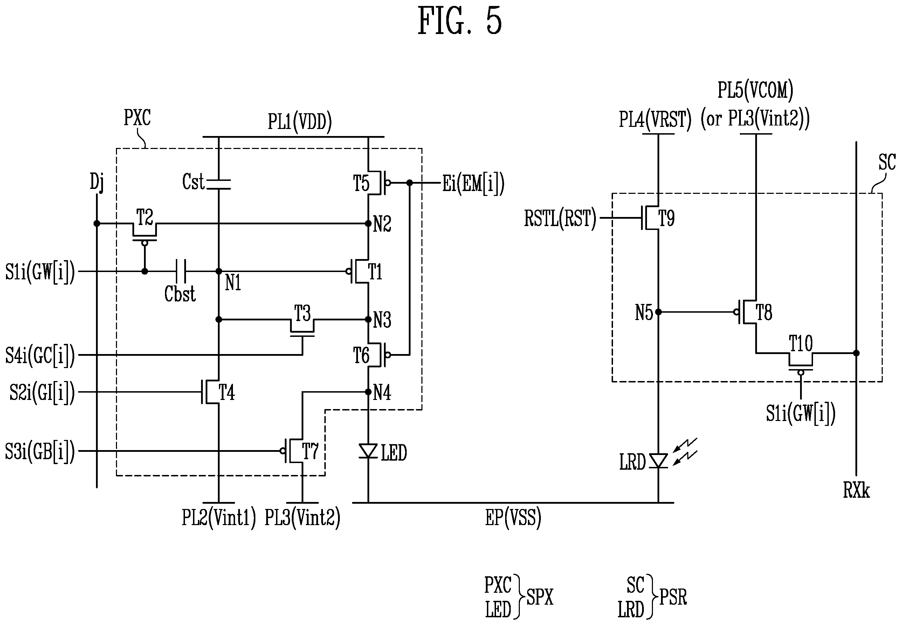

The subpixel SPX may be electrically connected to at least one of the scan lines S1 through Sn and at least one of the data lines D1 through Dm. The light-sensing pixel PSR may be electrically connected to one of the scan lines S1 through Sn, one of the readout lines RX1 through RXo, and the reset line RSTL. The connection configuration between the subpixel SPX, the light-sensing pixel PSR, and the signal wiring shall be described below with reference to FIG. 5.

Power voltages VDD, VSS, VRST, VCOM desired to drive the subpixel SPX and the light-sensing pixel PSR may be provided to the display panel 100. The power voltages VDD, VSS, VRST, VCOM may be supplied from a power supplier. The power supplier may be implemented as a power management integrated circuit ("PMIC").

The driving circuit 200 may include a scan driver 211, a data driver 212, a controller 213, a reset circuit 221, and a readout circuit 222. In an embodiment, the scan driver 211, the data driver 212, and the controller 213 may be included in the panel driver 210, and the reset circuit 221 and the readout circuit 222 may be included in the sensor driver 220, for example, which are not limited thereto. In embodiments, the reset circuit 221 may be included in the panel driver 210.

The scan driver 211 may be electrically connected to the subpixel SPX and the light-sensing pixel PSR through the scan lines S1 through Sn. The scan driver 211 may generate scan signals based on a scan control signal SCS, and supply the scan signals to the scan lines S1 through Sn. The scan control signal SCS may include an initiation signal, a clock signal, and so on, and may be provided from the controller 213 to the scan driver 211. In an embodiment, the scan driver 211 may be implemented as a shift register which sequentially shifts an initiation signal in the form of pulses using clock signals to generate and output the scan signals, for example. The scan driver 211 may selectively drive the subpixel SPX and the light-sensing pixel PSR while scanning the display panel 100.

The scan driver 211 may be formed together with the subpixel SPX of the display panel 100, but is not limited thereto. In embodiments, the scan driver 211 may be implemented as an integrated circuit.

The subpixel SPX selectively driven by the scan driver 211 may emit light with a luminance corresponding to the data signal provided to the corresponding data line among the data lines D1 through Dm. The light-sensing pixel PSR selectively driven by the scan driver 211 may output an electrical signal (e.g., a sensing signal) corresponding to the detected light to the corresponding readout line. In an embodiment, the subpixel SPX selectively driven by the i-th scan line Si may emit light with a luminance corresponding to a data signal fed to the j-th data line Dj (where, i and j are natural numbers equal to or less than n and m respectively), for example. In an embodiment, the light-sensing pixel PSR selectively driven by the i-th scan line Si may output an electrical signal corresponding to the detected light to the k-th readout line RXk (where, k is a natural number greater than 0), for example.

The data driver 212 may generate a data signal (or a data voltage) based on image data DATA2 and a data control signal DCS provided from the controller 213, and supply the data signal to the display panel 100 (or the subpixel SPX) through the data lines D1 through Dm. The data control signal DCS is a signal for controlling the operation of the data driver 212, and may include a horizontal initiation signal, a data clock signal, and so on. In an embodiment, the data driver 212 may include a shift register for synchronizing with a data clock signal to shift the horizontal initiation signal and thus to generate a sampling signal, a latch for latching the image data DATA2 in response to the sampling signal, a digital-to-analog converter (or a decoder) for converting the latched image data (e.g., digital data) into an analog data signal, and a buffer (or an amplifier) for outputting the data signal to a corresponding data line (e.g., the j-th data line Dj), for example.

The controller 213 may receive input image data DATA1 and a control signal CS from an external device (e.g., a graphics processor, an application processor, a first processor), generate a scan control signal SCS and a data control signal DCS based on the control signal CS, and generate the image data DATA2 by converting the input image data DATA1. The control signal CS may include a vertical synchronization signal, a horizontal synchronization signal, a reference clock signal, or the like. The vertical synchronization signal may indicate a start of frame data (i.e., data corresponding to a frame segment displaying a single frame image), and the horizontal synchronization signal may indicate a start of a data row (i.e., one data row among a plurality of data rows included in the frame data). The controller 213 may convert the input image data DATA1 into the image data DATA2 with a format corresponding to the pixel arrangement in the display panel 100.

The controller 213 may generate a reset control signal and a readout control signal RCS based on the control signal CS.

The reset circuit 221 may be commonly connected to every light-sensing pixel PSR provided in the display panel 100 via the single reset line RSTL. The reset circuit 221 may simultaneously supply the reset signal RST to every light-sensing pixel PSR in response to the reset control signal. Since the reset signal RST is simultaneously provided to every light-sensing pixel PSR, the reset signal RST may be also referred to as a global reset signal.

The readout circuit 222 may receive a sensing signal from the light-sensing pixel PSR through the readout lines RX1 through RXo, and perform signal processing on the sensing signal.

In an embodiment, the readout circuit 222 may perform a correlated double sampling ("CDS") operation to remove noise from the sensing signal provided by the light-sensing pixel PSR, for example. A timing of the correlated double sampling operation of the readout circuit 222 may be determined by the readout control signal RCS. The readout circuit 222 may convert the analog sensing signal into a digital signal (or a digital value). The configuration for the correlated double sampling and the analog-to-digital conversion may be provided for each of the readout lines RX1 through RXo, and the readout circuit 222 may process sensing signals provided by the readout lines RX1 through RXo in parallel.

The processed sensing signals, i.e., readout sensing signals may be forwarded to an external device (e.g., an application processor) as one sensing data (or biometric information), to perform biometric authentication (e.g., fingerprint authentication, etc.) based on the sensing data. In embodiments, the readout sensing signals may be provided to the controller 213, to perform the biometric authentication at the controller 213.

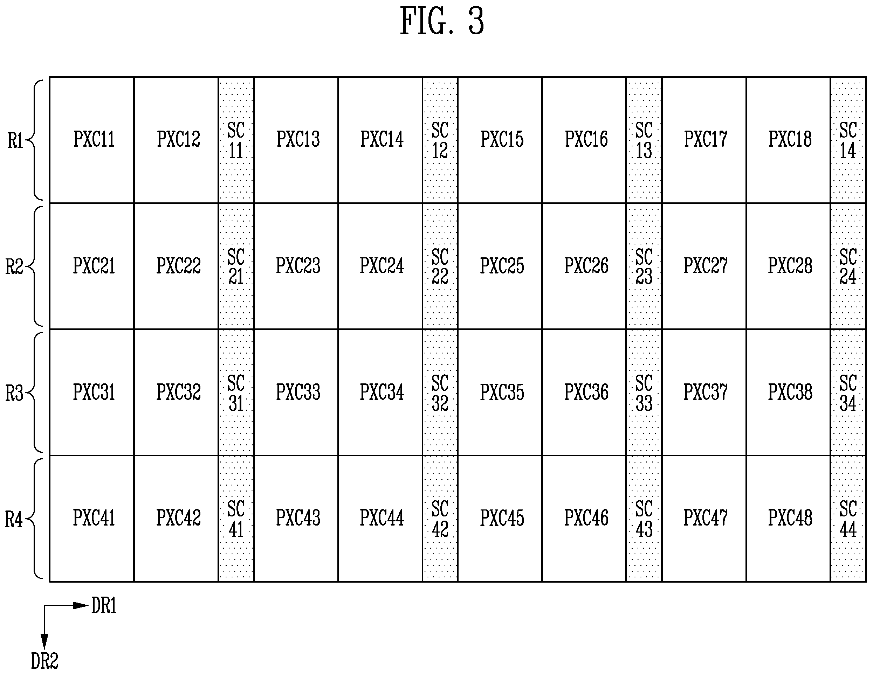

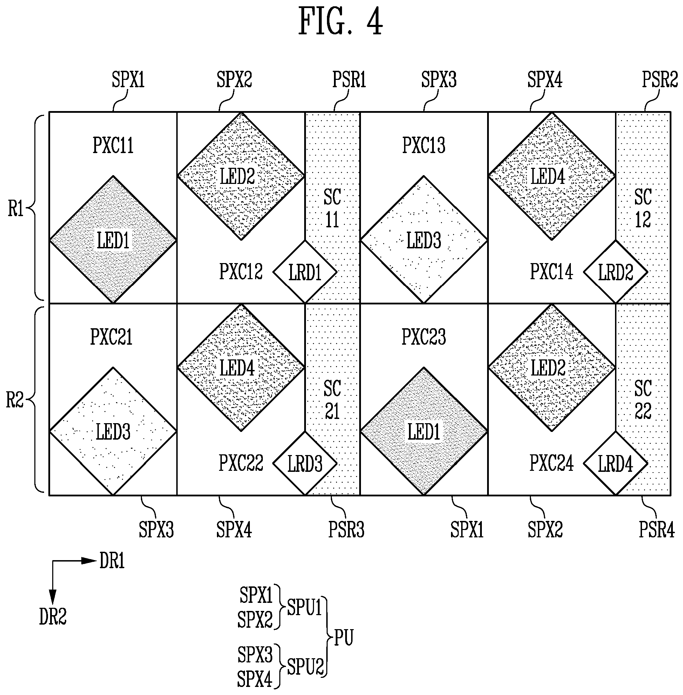

FIG. 3 is a schematic diagram illustrating an embodiment of arrangement of pixel circuits and sensor circuits in the display area DA of the display panel 100 included in the display device 1 of FIG. 2, and FIG. 4 is a schematic diagram illustrating an embodiment of the display area of the display panel included in the display device of FIG. 2.

Referring to FIG. 1 through FIG. 4, subpixels SPX1 through SPX4 and a plurality of light-sensing pixels PSR1 through PSR4 may be arranged in the display area (refer to "DA" of FIG. 1) of the display panel (refer to "100" of FIG. 1).

The display area DA may be divided into pixel rows R1 through R4. The pixel rows R1 through R4 each may extend in a first direction DR1, and may be arranged in a second direction DR2. The pixel rows R1 through R4 each may include the subpixels SPX1 through SPX4. Each of the subpixels SPX1 through SPX4 may include one of pixel circuits PXC11 through PXC48 and one of light-emitting elements LED1 through LED4.

In embodiments, the first subpixel SPX1, the second subpixel SPX2, and the third subpixel SPX3 may emit light of a first color, light of a second color, and light of a third color respectively. The light of the first color, the light of the second color, and the light of the third color may be light of different colors. The light of the first color, the light of the second color, and the light of the third color each may be one of red light, green light, and blue lights. The first light-emitting element LED1 for emitting the light of the first color may be disposed in the first subpixel SPX1, the second light-emitting element LED2 for emitting the light of the second color may be disposed in the second subpixel SPX2, the third light-emitting element LED3 for emitting the light of the third color may be disposed in the third subpixel SPX3, and the fourth light-emitting element LED4 for emitting the light of the second color may be disposed in the fourth subpixel SPX4. The second light-emitting element LED2 and the fourth light-emitting element LED4 may emit light of the same color.

In FIG. 4, the light-emitting elements LED1 through LED4 each may be understood as the light-emitting area corresponding to the light-emitting layer. However, this is for the convenience of explanation, and the color of the light emitted by each of the light-emitting elements LED1 through LED4, and the position, the area, and the shape of each of the light-emitting elements LED1 through LED4 are not limited thereto.

In embodiments, in each of the odd-numbered pixel rows including the first pixel row R1 (or a first horizontal line) and the third pixel row R3 (or a third horizontal line), the subpixels SPX1 through SPX4 may be arranged for the first direction DR1 in order of the first subpixel SPX1 for emitting the red light, the second subpixel SPX2 for emitting the green light, the third subpixel SPX3 for emitting the blue light, and the fourth subpixel SPX4 for emitting the green light.

In each of the even-numbered pixel rows including the second pixel row R2 (or a second horizontal line) and the fourth pixel row R4 (or a fourth horizontal line), the subpixels SPX1 through SPX4 may be arranged for the first direction DR1 in order of the third subpixel SPX3, the fourth subpixel SPX4, the first subpixel SPX1, and the second subpixel SPX2.

In embodiments, the first subpixel SPX1 and the second subpixel SPX2 may configure a first subpixel unit SPU1, and the third subpixel SPX3 and the fourth subpixel SPX4 may configure a second subpixel unit SPU2. The first subpixel unit SPU1 and the second subpixel unit SPU2 may be alternately arranged in the odd-numbered pixel rows R1, R3, and the second subpixel unit SPU2 and the first subpixel unit SPU1 may be alternately arranged in the even-numbered pixel rows R2, R4 contrary to the arrangement thereof on the odd-numbered pixel rows R1, R3.

It may be understood that predetermined first and second subpixel units SPU1, SPU2 next (adjacent) to each other configure one pixel unit PU. In an embodiment, FIG. 4 shows the pixel unit PU of each of the first pixel row R1 and the second pixel row R2, for example. However, embodiments are not limited thereto, and the arrangement of the subpixels SPX1 through SPX4 may be variously changed.

In the first pixel row R1, the pixel circuits PXC11 through PXC18 corresponding to the subpixels SPX1 through SPX4 respectively of the first pixel row R1 may be arranged in the first direction DR1. In the second pixel row R2, the pixel circuits PXC21 through PXC28 corresponding to the subpixels SPX1 through SPX4 respectively of the second pixel row R2 may be arranged in the first direction DR1. In the third pixel row R3, the pixel circuits PXC31 through PXC38 corresponding to the subpixels SPX1 through SPX4 respectively of the third pixel row R3 may be arranged in the first direction DR1. In the fourth pixel row R4, the pixel circuits PXC41 through PXC48 corresponding to the subpixels SPX1 through SPX4 respectively of the fourth pixel row R4 may be arranged in the first direction DR1.

In FIG. 3, the first, second, third, and fourth pixel circuits PXC11, PXC12, PXC13, PXC14 of the first pixel row R1 may be included in one pixel unit PU (or a first pixel unit), and the fifth, sixth, seventh, and eighth pixel circuits PXC15, PXC16, PXC17, PXC18 of the first pixel row R1 may be included in another pixel unit PU (or a second pixel unit).

Similarly, the first through fourth pixel circuits PXC21 through PXC24 of the second pixel row R2, the fifth through eighth pixel circuits PXC25 through PXC28 of the second pixel row R2, the first through fourth pixel circuits PXC31 through PXC34 of the third pixel row R3, the fifth through eighth pixel circuits PXC35 through PXC38 of the third pixel row R3, the first through fourth pixel circuits PXC41 through PXC44 of the fourth pixel row R4, and the fifth through eighth pixel circuits PXC45 through PXC48 of the fourth pixel row R4 may be included in different pixel units PU as well.

In embodiments, each of the pixel rows R1 through R4 may include light-receiving elements LRD1 through LRD4. In FIG. 4, the light-receiving elements LRD1 through LRD4 may be understood as the light-receiving areas corresponding to the light-receiving layers, respectively. However, this is for the convenience of explanation, and the position, the area, and the shape of the light-receiving elements LRD1 through LRD4 may be variously changed.

Each of the light-receiving elements LRD1 through LRD2 of the first pixel row R1 may overlap at least a part of the pixel circuits PXC11 through PXC14 of the first pixel row R1 and the sensor circuits SC11, SC12 of the first pixel row R1. The light-receiving elements LRD3, LRD4 of the second pixel row R2 each may overlap at least a part of the pixel circuits PXC21 through PXC24 of the second pixel row R2 and the sensor circuits SC21, SC22 of the second pixel row R2.

In embodiments, the first light-receiving element LRD1 may overlap at least a part of the first sensor circuit SC11 of the first pixel row R1, and the third light-receiving element LRD3 may overlap at least a part of the first sensor circuit SC21 of the second pixel row R2.

The second light-receiving element LRD2 may overlap at least a part of the second sensor circuit SC12 of the first pixel row R1, and the fourth light-receiving element LRD4 may overlap at least a part of the second sensor circuit SC22 of the second pixel row R2.

The light-receiving elements LRD1 through LRD4 may be formed in the display area DA in the same arrangement as shown in FIG. 4, but embodiments are not limited thereto.

In embodiments, the sensor circuits SC11 through SC44 may be electrically connected to the corresponding light-receiving element. The first sensor circuit SC11 of the first pixel row R1 may be electrically connected to the first light-receiving element LRD1 to form a first light-sensing pixel PSR1. In other words, the first sensor circuit SC11 and the first light-receiving element LRD1 may configure the first light-sensing pixel PSR1. The second sensor circuit SC12 of the first pixel row R1 may configure a second light-sensing pixel PSR2 electrically connected to the second light-receiving element LRD2. In other words, the second sensor circuit SC12 and the second light-receiving element LRD2 may configure the second light-sensing pixel PSR2. The first sensor circuit SC21 of the second pixel row R2 may be electrically connected to the third light-receiving element LRD3 to form a third light-sensing pixel PSR3. In other words, the first sensor circuit SC21 and the third light-receiving element LRD3 may configure the third light-sensing pixel PSR3. The second sensor circuit SC22 of the second pixel row R2 may be electrically connected to the fourth light-receiving element LRD4 to form a fourth light-sensing pixel PSR4. In other words, the second sensor circuit SC22 and the fourth light-receiving element LRD4 may configure the fourth light-sensing pixel PSR4. However, embodiments are not limited thereto, and in embodiments, only a part of the sensor circuits SC11 through SC44 may be provided, and the part may be connected to a plurality of light-receiving elements.

The first sensor circuit SC11 of the first pixel row R1 may be disposed between the first subpixel unit SPU1 and the second subpixel unit SPU2 included in the pixel unit PU. In an embodiment, the first and second pixel circuits PXC11, PXC12 of the first pixel row R1 may be included in the first subpixel unit SPU1, and the third and fourth pixel circuits PXC13, PXC14 of the first pixel row R1 may be included in the second subpixel unit SPU2, for example. Hence, at least two pixel circuits (e.g., the third and fourth pixel circuits PXC13 and PXC14) may be disposed between the first sensor circuit SC11 and the second sensor circuit SC12 which are next (adjacent) to each other in the first pixel row R1.

The second sensor circuit SC12 of the first pixel row R1, the first sensor circuit SC21 of the second pixel row R2, and the second sensor circuit SC22 of the second pixel row R2 may be disposed between the first subpixel unit SPU1 and the second subpixel unit SPU2, similar to the first sensor circuit SC11 of the first pixel row R1.

FIG. 5 is a schematic diagram illustrating an embodiment of a subpixel SPX and a light-sensing pixel PSR included in the display area DA of FIG. 1. FIG. 5 shows a subpixel SPX disposed in an i-th horizontal line (or an i-th pixel row) and connected to the j-th data line Dj for the ease of explanation.

Referring to FIG.1 and FIG. 5, the subpixel SPX and the light-sensing pixel PSR may be disposed in the i-th horizontal line.

The subpixel SPX may include a light-emitting element LED and a pixel circuit PXC. In embodiments, the pixel circuit PXC may include first, second, third, fourth, fifth, sixth, and seventh transistors T1, T2, T3, T4, T5, T6, T7, a storage capacitor Cst, and a boost capacitor Cbst.

The first transistor T1 (or a driving transistor) may be electrically connected between first power wiring PL1 and a first electrode (or an anode electrode) of the light-emitting element LED. The first transistor T1 may include a gate electrode electrically connected to a first node N1. The first transistor T1 may control the amount of current (or driving current) flowing from the first power wiring PL1 to an electrode EP (or power wiring) via the light-emitting element LED based on a voltage of the first node N1. A first power voltage VDD may be supplied to the first power wiring PL1, a second power voltage VSS may be provided to the electrode EP, and the first power voltage VDD may be set to a higher voltage than the second power voltage VSS.

The second transistor T2 may be electrically connected between the j-th data line Dj and a second node N2. A gate electrode of the second transistor T2 may be connected to a 1i-th scan line S1i (or a first scan line). The second transistor T2 may be turned on when a first scan signal GW[i] (e.g., a low-level first scan signal) is supplied to the 1i-th scan line S1i to electrically interconnect the j-th data line Dj and the second node N2. When the first transistor T1 and the third transistor T3 each are in a turn-on state, the second transistor T2 may forward a data signal of the j-th data line Dj to the second node N2 in response to the first scan signal GW[i].

The third transistor T3 may be electrically connected between the first node N1 and a third node N3. A gate electrode of the third transistor T3 may be electrically connected to a 4i-th scan line S4i (or a third scan line). The third transistor T3 may be turned on when a fourth scan signal GC[i] is supplied to the 4i-th scan line S4i.

The fourth transistor T4 may be electrically connected between the first node N1 and the second power wiring PL2. A gate electrode of the fourth transistor T4 may be electrically connected to a 2i-th scan line S2i (or a second scan line). The second power wiring PL2 may be provided with a first initialization power voltage Vint1. The fourth transistor T4 may be turned on by a second scan signal GI[i] supplied to the 2i-th scan line S2i. When the fourth transistor T4 is turned on, the first initialization power voltage Vint1 may be supplied to the first node N1 (i.e., the gate electrode of the first transistor T1).

The fifth transistor T5 may be electrically connected between the first power wiring PL1 and the second node N2. A gate electrode of the fifth transistor T5 may be electrically connected to an i-th emission control line Ei. The sixth transistor T6 may be electrically connected between the third node N3 and the light-emitting element LED (or the fourth node N4). A gate electrode of the sixth transistor T6 may be electrically connected to the i-th emission control line Ei. The fifth transistor T5 and the sixth transistor T6 may be turned off when an emission control signal EM[i] (e.g., a high-level emission control signal EM[i]) is supplied to the i-th emission control line Ei, and may be turned on otherwise.

The seventh transistor T7 may be electrically connected between the first electrode (i.e., the fourth node N4) of the light-emitting element LED and the third power wiring PL3. A gate electrode of the seventh transistor T7 may be electrically connected to the 3i-th scan line S3i (or a fourth scan line). The third power wiring PL3 may be supplied with a second initialization power voltage Vint2. In embodiments, the second initialization power voltage Vint2 may be equal to or different from the first initialization power voltage Vint1. The seventh transistor T7 may be turned on by a third scan signal GB[i] supplied to the 3i-th scan line S3i to supply the second initialization power voltage Vint2 to the first electrode of the light-emitting element LED.

The storage capacitor Cst may be connected or formed between the first power wiring PL1 and the first node N1.

The boost capacitor Cbst (or a capacitor) may be connected or formed between the gate electrode of the second transistor T2 and the gate electrode of the first transistor T1.

The light-sensing pixel PSR may include a sensor circuit SC and a light-receiving element LRD. The sensor circuit SC may include eighth, ninth, and tenth transistors T8, T9, T10.

The eighth and tenth transistors T8, T10 may be connected in series between a fifth power wiring PL5 and a k-th readout line RXk (where, k is a natural number greater than 0).

The eighth transistor T8 (or a first sensor transistor) may be electrically connected between the fifth power wiring PL5 and the tenth transistor T10. The gate electrode of the eighth transistor T8 may control the current flowing from the fifth power wiring PL5 to the k-th readout line RXk through the tenth transistor T10 in response to a voltage of a fifth node N5. The common voltage VCOM may be supplied to the fifth power wiring PL5.

In embodiments, the fifth power wiring PL5 may be electrically connected to or unitary with the third power wiring PL3, and the common voltage VCOM applied to the fifth power wiring PL5 may be equal to the second initialization power voltage Vint2, but is not limited thereto. In another embodiment, the fifth power wiring PL5 may be electrically connected to or unitary with the second power wiring PL2, and the common voltage VCOM applied to the fifth power wiring PL5 may be equal to the first initialization power voltage Vint1.

The tenth transistor T10 (a "second sensor transistor" or a "switching transistor") may be electrically connected between the eighth transistor T8 and the k-th readout line RXk. A gate electrode of the tenth transistor T10 may be connected to the 1i-th scan line S1i. In other words, the gate electrode of the tenth transistor T10 and the gate electrode of the second transistor T2 may share the 1i-th scan line S1i.

The ninth transistor T9 (or a third sensor transistor) may be electrically connected between the fourth power wiring PL4 (or reference power wiring or reset voltage wiring) and the fifth node N5. A gate electrode of the ninth transistor T9 may be electrically connected to the reset line RSTL. The reset voltage VRST may be supplied to the fourth power wiring PL4. The reset voltage VRST may be a direct current voltage having a constant level. In an embodiment, the reset voltage VRST may be about -7 volts (V), for example, but embodiments are not limited thereto.

At least one light-receiving element LRD may be electrically connected between the fifth node N5 and the electrode EP to which the second power voltage VSS is provided.

The light-receiving element LRD may generate an electric charge (or current) based on the incident light. In other words, the light-receiving element LRD may perform a photoelectric conversion function. In an embodiment, the light-receiving element LRD may be implemented as a photodiode, for example.

When the ninth transistor T9 is turned on by the reset signal RST supplied to the reset line RSTL, the reset voltage VRST may be supplied to the fifth node N5. In an embodiment, the voltage of the fifth node N5 may be reset by the reset voltage VRST, for example. The light-receiving element LRD may perform the photoelectric conversion function after the reset voltage VRST is applied to the fifth node N5.

The voltage of the fifth node N5 may be changed by the operation of the light-receiving element LRD. The voltage of the fifth node N5 (or the charge or current generated by the light-receiving element LRD) may vary depending on an intensity of the light incident on the light-receiving element LRD and a time of the light incidence (or a time for which the light-receiving element LRD is exposed to the light).

When the tenth transistor T10 is turned on by the first scan signal GW[i] supplied to the 1i-th scan line S1i, a detection value (current and/or voltage) generated based on the voltage of the fifth node N5 may flow to the k-th readout line RXk.

In embodiments, the pixel circuit PXC and the sensor circuit SC each may include a P-type transistor and an N-type transistor. The third transistor T3, the fourth transistor T4, and the ninth transistor T9 may be formed with an oxide semiconductor transistor including an oxide semiconductor (or a second type semiconductor). In an embodiment, the third transistor T3, the fourth transistor T4, and the ninth transistor T9 may be N-type oxide semiconductor transistors, and may include an oxide semiconductor layer as an active layer, for example, but embodiments are not limited thereto.

The remaining transistors (e.g., the first, second, fifth, sixth, seventh, eighth, and tenth transistors T1, T2, T5, T6, T7, T8, T10) may be formed with a polysilicon transistor including a silicon semiconductor (or a first type semiconductor), and may include a polysilicon semiconductor layer as the active layer. In an embodiment, the active layer may be formed through a low-temperature polysilicon process (e.g., a low-temperature poly-silicon ("LTPS") process), for example.

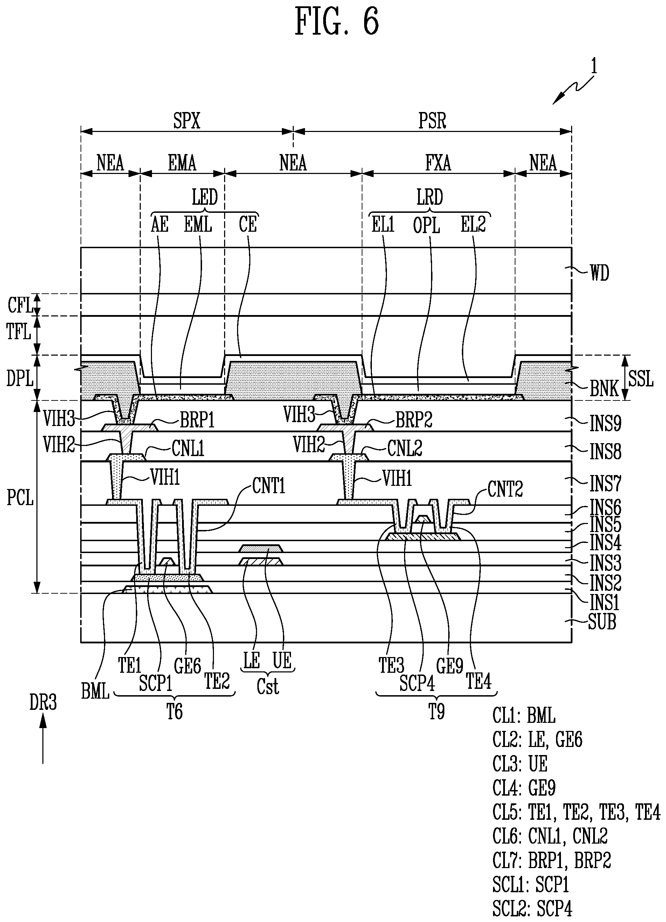

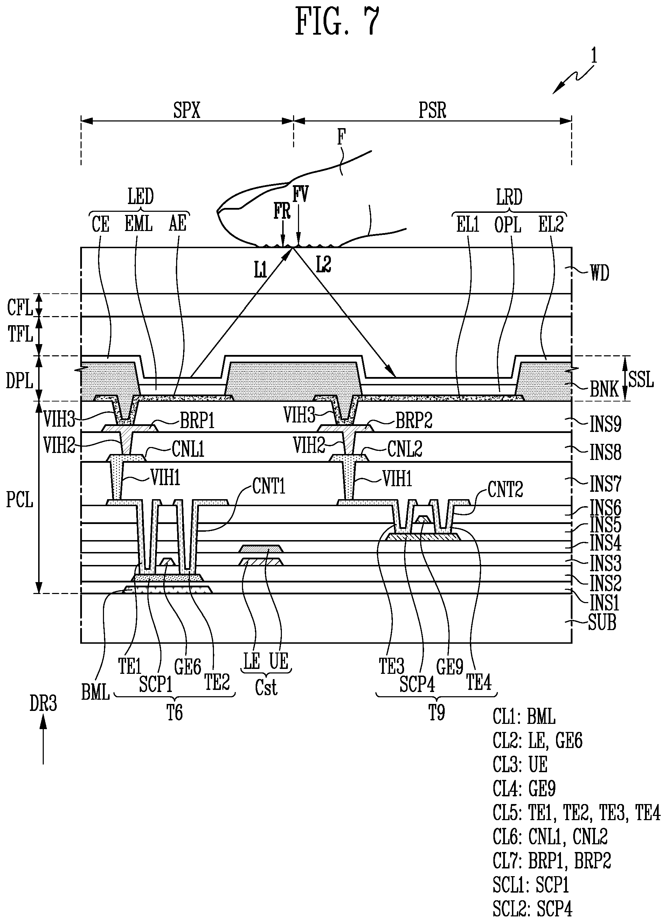

Hereafter, referring to FIG. 6 and FIG. 7, a stacking structure (or a cross-sectional structure) of the subpixel SPX including the light-emitting element LED and the light-sensing pixel PSR including the light-receiving element LRD is described.

FIG. 6 is a schematic cross-sectional diagram illustrating an embodiment of one area of a display device 1, and FIG. 7 is a schematic cross-sectional diagram illustrating a reflection path of light in the display device 1 of FIG. 6.

In FIG. 6 and FIG. 7, the cross-section of the part corresponding to the sixth transistor T6 in the pixel circuit PXC shown in FIG. 5 and the cross-section of the part corresponding to the ninth transistor T9 in the sensor circuit SC are depicted.

Referring to FIG. 1 through FIG. 7, the display device 1 may include the subpixel SPX and the light-sensing pixel PSR arranged in one area of a substrate SUB.

A pixel circuit layer PCL of the subpixel SPX and a pixel circuit layer PCL of the light-sensing pixel PSR may be disposed on the substrate SUB. At least one insulating layer may be disposed in the pixel circuit layer PCL. The insulating layer may include a first insulating layer INS1, a second insulating layer INS2, a third insulating layer INS3, a fourth insulating layer INS4, a fifth insulating layer INS5, a sixth insulating layer INS6, a seventh insulating layer INS7, an eighth insulating layer INS8, and a ninth insulating layer INS9 sequentially stacked on the substrate SUB along the third direction DR3.

The first insulating layer INS1 (or a buffer layer) may be disposed on the substrate SUB. The first insulating layer INS1 may prevent impurities from diffusing onto the sixth transistor T6 and the ninth transistor T9. The first insulating layer INS1 may be an inorganic film including an inorganic material (or substance). The first insulating layer INS1 may include at least one of silicon nitride (SiNₓ), silicon oxide (SiOₓ), silicon oxide (SiOₓN_{y}), and aluminum oxide (AlOₓ). The first insulating layer INS1 may be provided as a single layer, but may be also provided as a multi-layer of at least two or more layers. The first insulating layer INS1 may be omitted depending on the material and process conditions of the substrate SUB.

The second insulating layer INS2 (or a first gate insulating layer) may be disposed on the first insulating layer INS1. The second insulating layer INS2 may include the same material as that of the first insulating layer INS1 or may include a material appropriate (or selected) from the materials exemplified as the material of the first insulating layer INS1. In an embodiment, the second insulating layer INS2 may be an inorganic film including an inorganic material, for example.

The third insulating layer INS3 (or a second gate insulating layer) may be disposed on the second insulating layer INS2. The third insulating layer INS3 may include the same material as that of the first insulating layer INS1 or include one or more materials appropriate (or selected) from the materials exemplified as the material of the first insulating layer INS1.

The fourth insulating layer INS4 (or a first inter-insulating layer) may be disposed on the third insulating layer INS3. The fourth insulating layer INS4 may be an inorganic film including an inorganic material or an organic film including an organic material.

The fifth insulating layer INS5 (or a third gate insulating layer) may be disposed on the fourth insulating layer INS4. The fifth insulating layer INS5 may be an inorganic film including an inorganic material or an organic film including an organic material.

The sixth insulating layer INS6 (or a second inter-insulating layer) may be disposed on the fifth insulating layer INS5. The sixth insulating layer INS6 may be an inorganic film including an inorganic material or an organic film including an organic material.

The seventh insulating layer INS7 (or a first via layer) may be disposed on the sixth insulating layer INS6. The seventh insulating layer INS7 may be an inorganic film including an inorganic material or an organic film including an organic material. The inorganic film may include at least one of silicon oxide (SiOₓ), silicon nitride (SiNₓ), silicon oxide (SiOₓN_{y}), and aluminum oxide (AlOₓ), for example. The organic film may include at least one of acrylic resin, epoxy resin, phenolic resin, polyamides resin, polyimides resin, unsaturated polyesters resin, poly-phenylene ethers resin, poly-phenylene sulfides resin, and benzocyclobutene resin, for example. In embodiments, the seventh insulating layer INS7 may be an organic film.

The eighth insulating layer INS8 (or a second via layer) may be disposed on the seventh insulating layer INS7. The eighth insulating layer INS8 may include the same material as that of the seventh insulating layer INS7 or include one or more materials appropriate (or selected) from the materials exemplified as the material of the seventh insulating layer INS7. In an embodiment, the eighth insulating layer INS8 may be an organic film including an organic material, for example.

The ninth insulating layer INS9 (or a third via layer) may be disposed on the eighth insulating layer INS8. The ninth insulating layer INS9 may include the same material as that of the seventh insulating layer INS7 or include one or more materials appropriate (or selected) from the materials exemplified as the material of the seventh insulating layer INS7. In an embodiment, the ninth insulating layer INS9 may be an organic film including an organic material, for example.

The pixel circuit layer PCL may include at least one or more conductive layers disposed between the above-described insulating layers. In an embodiment, the conductive layers may include a first conductive layer CL1 disposed between the substrate SUB and the first insulating layer INS1, a second conductive layer CL2 disposed between the second insulating layer INS2 and the third insulating layer INS3, a third conductive layer CL3 disposed between the third insulating layer INS3 and the fourth insulating layer INS4, a fourth conductive layer CL4 disposed between the fifth insulating layer INS5 and the sixth insulating layer INS6, a fifth conductive layer CL5 disposed between the sixth insulating layer INS6 and the seventh insulating layer INS7, a sixth conductive layer CL6 disposed between the seventh insulating layer INS7 and the eighth insulating layer INS8, and a seventh conductive layer CL7 disposed between the eighth insulating layer INS8 and the ninth insulating layer INS9, for example. The insulating layers and the conductive layers are not limited to the above-described embodiment, and other insulating layer and other conductive layer than the insulating layers and the conductive layers may be disposed in the pixel circuit layer PCL in embodiments.

In embodiments, a first semiconductor layer SCL1 may be disposed between the first insulating layer INS1 and the second insulating layer INS2. The first semiconductor layer SCL1 may include a silicon semiconductor. In an embodiment, the silicon semiconductor may include amorphous silicon, polycrystalline silicon, and so on, for example. The first semiconductor layer SCL1 may include, but not limited to, cryogenic polysilicon. The first semiconductor layer SCL1 may include a first semiconductor area with relatively high conductivity and a second semiconductor area with relatively low conductivity. The first semiconductor area may be doped with either an N-type dopant or a P-type dopant. A P-type transistor may include a doping area doped with the P-type dopant, and a N-type transistor may include a doping area doped with the N-type dopant. The second semiconductor area may be a non-doping area or an area dopped at a lower concentration than the first semiconductor area. The conductivity of the first semiconductor area may be greater than the conductivity of the second semiconductor area. The first semiconductor area may substantially serve as an electrode or signal wiring. The second semiconductor area may substantially correspond to an active pattern (or a channel area) of the transistor. A part of the first semiconductor layer SCL1 may be an active pattern area of the transistor, another part of the first semiconductor layer SCL1 may be a source/drain area (or a source/drain electrode) of the transistor, and yet another part of the first semiconductor layer SCL1 may be a connection electrode or connection signal wiring, which are not limited thereto.

In embodiments, a second semiconductor layer SCL2 may be disposed between the fourth insulating layer INS4 and the fifth insulating layer INS5. The second semiconductor layer SCL2 may include an oxide semiconductor. The oxide semiconductor may include a plurality of areas divided by whether metal oxide is reduced or not. The area of the reduced metal oxide (hereafter, also referred to as a "reduction area") may have greater conductivity than an area not reduced (hereafter, also referred to as a "non-reduction area"). The reduction area may be utilized substantially as the source/drain area of the transistor or as the signal wiring. The non-reduction area may substantially correspond to the active pattern (or the channel area) of the transistor. A part of the second semiconductor layer SCL2 may be the active pattern of the transistor, another part of the second semiconductor layer SCL2 may be the source/drain area (or source/drain electrode) of the transistor, and yet another part may be the signaling area, which are not limited thereto.

The sixth transistor T6 and the ninth transistor T9 may be disposed in the pixel circuit layer PCL.

The sixth transistor T6 may include a gate electrode GE6 (hereafter, also referred to as a "sixth gate electrode"), a first semiconductor pattern SCP1, a first terminal TE1, and a second terminal TE2. The ninth transistor T9 may include a gate electrode GE9 (hereafter, also referred to as a "ninth gate electrode"), a fourth semiconductor pattern SCP4, a third terminal TE3, and a fourth terminal TE4.

The first semiconductor pattern SCP1 may be disposed on the first insulating layer INS1, and may be included in the first semiconductor layer SCL1. The first semiconductor pattern SCP1 may include a channel area (or a second semiconductor area), a 1-1 semiconductor area connected to one end of the channel area, and a 1-2 semiconductor area connected to an opposite end of the channel area. The second insulating layer INS2 may be disposed on the first semiconductor pattern SCP1.

The sixth gate electrode GE6 may be disposed on the second insulating layer INS2, and may include the second conductive layer CL2. The second conductive layer CL2 may be formed as a single layer or a multi-layer including molybdenum, copper, chromium, gold, silver, titanium, nickel, neodymium, indium, tin, and an oxide or any alloys thereof. In an embodiment, the second conductive layer CL2 may form, but not limited to, a multi-layer where titanium, copper, and/or indium tin oxide are stacked sequentially or repeatedly, for example. The sixth gate electrode GE6 may overlap with one area of the first semiconductor pattern SCP1. One area of the first semiconductor pattern SCP1 overlapping with the sixth gate electrode GE6 may be the channel area of the sixth transistor T6. The third insulating layer INS3 may be disposed on the sixth gate electrode GE6.

The first terminal TE1 and second terminal TE2 may be disposed on the sixth insulating layer INS6. The first terminal TE1 and the second terminal TE2 may be included in the fifth conductive layer CL5. The fifth conductive layer CL5 may be formed as a single layer or a multi-layer including molybdenum, copper, aluminum, chromium, gold, silver, titanium, nickel, neodymium, indium, tin, and an oxide or any alloys thereof.

The first terminal TE1 may be electrically connected to the 1-2 semiconductor area of the first semiconductor pattern SCP1 through a first contact CNT1 which penetrates the second insulating layer INS2, the third insulating layer INS3, the fourth insulating layer INS4, the fifth insulating layer INS5, and the sixth insulating layer INS6. The first terminal TE1 may be electrically connected to an anode electrode AE of the light-emitting element LED. The second terminal TE2 may be electrically connected to the 1-1 semiconductor area of the first semiconductor pattern SCP1 through another first contact CNT1 which penetrates the second insulating layer INS2, the third insulating layer INS3, the fourth insulating layer INS4, the fifth insulating layer INS5, and the sixth insulating layer INS6.

The seventh insulating layer INS7 may be disposed on the first terminal TE1 and the second terminal TE2.

The fourth semiconductor pattern SCP4 may be disposed on the fourth insulating layer INS4. The fourth semiconductor pattern SCP4 may include the second semiconductor layer SCL2. The fourth semiconductor pattern SCP4 may include a channel area (or a non-reduction area), a first reduction area connected to one end of the channel area, and a second reduction area connected to an opposite end of the channel area. The fifth insulating layer INS5 may be disposed on the fourth semiconductor pattern SCP4.

The ninth gate electrode GE9 may be disposed on the fifth insulating layer INS5. The ninth gate electrode GE9 may be included in the fourth conductive layer CL4. The fourth conductive layer CL4 may include the same material as that of the second conductive layer CL2 or the fifth conductive layer CL5, or may include a material appropriate (or selected) from the materials exemplified as the material of the second conductive layer CL2 or the fifth conductive layer CL5. A ninth gate electrode GE9 may overlap with one area of the fourth semiconductor pattern SCP4. One area of the fourth semiconductor pattern SCP4 overlapping with the ninth gate electrode GE9 may be the channel area of the ninth transistor T9.

The sixth insulating layer INS6 may be disposed on the ninth gate electrode GE9.

The third terminal TE3 and the fourth terminal TE4 may be disposed on the sixth insulating layer INS6. The third terminal TE3 and the fourth terminal TE4 may be included in the fifth conductive layer CL5.

The third terminal TE3 may be electrically connected to the first reduction area of the fourth semiconductor pattern SCP4 via a second contact CNT2 which penetrates the fifth insulating layer INS5 and the sixth insulating layer INS6. The fourth terminal TE4 may be electrically connected to the second reduction area of the fourth semiconductor pattern SCP4 via another second contact CNT2 which penetrates the fifth insulating layer INS5 and the sixth insulating layer INS6. The third terminal TE3 and the fourth terminal TE4 may be disposed apart from each other on the sixth insulating layer INS6. The seventh insulating layer INS7 may be disposed on the third terminal TE3 and the fourth terminal TE4.

The pixel circuit layer PCL may further include a lower metal pattern BML disposed on the substrate SUB. The lower metal pattern BML may be included in the first conductive layer CL1. The first conductive layer CL1 may include the same material as that of the second conductive layer CL2 or the fifth conductive layer CL5, or may include a material appropriate (or selected) from the materials exemplified as the material of the second conductive layer CL2 or the fifth conductive layer CL5. The lower metal pattern BML may overlap with the sixth transistor T6 and, in embodiments, may be electrically connected to the sixth transistor T6 to stabilize the channel area of the sixth transistor T6.

The storage capacitor Cst may be disposed in the pixel circuit layer PCL. The storage capacitor Cst may include a lower electrode LE and an upper electrode UE.

The lower electrode LE may be disposed on the second insulating layer INS2. The lower electrode LE may be included in the first conductive layer CL1 and may be provided in the same layer as the sixth gate electrode GE6, but embodiments are not limited thereto. The third insulating layer INS3 may be disposed on the lower electrode LE.

The upper electrode UE may be disposed on the third insulating layer INS3. The upper electrode UE may be included in, but not limited to, the third conductive layer CL3. The third conductive layer CL3 may include the same material as that of the second conductive layer CL2 or the fifth conductive layer CL5 or may include one more materials appropriate (or selected) from the materials exemplified as the material of the second conductive layer CL2 or the fifth conductive layer CL5. The upper electrode UE may overlap with the lower electrode LE with the third insulating layer INS3 interposed therebetween to form capacitor.

First connection wiring CNL1, second connection wiring CNL2, a first bridge pattern BRP1, and a second bridge pattern BRP2 may be disposed in the pixel circuit layer PCL.

The first connection wiring CNL1 and the second connection wiring CNL2 may be disposed on the seventh insulating layer INS7. The first connection wiring CNL1 and the second connection wiring CNL2 may include the sixth conductive layer CL6. The sixth conductive layer CL6 may include the same material as that of the second conductive layer CL2 or the fifth conductive layer CL5 or may include one or more materials appropriate (or selected) from the materials exemplified as the material of the second conductive layer CL2 or the fifth conductive layer CL5. The first connection wiring CNL1 may be electrically connected to the first terminal TE1 of the sixth transistor T6 through a first via hole VIH1 which penetrates the seventh insulating layer INS7. The second connection wiring CNL2 may be electrically connected to the third terminal TE3 of the ninth transistor T9 through another first via hole VIH1 which penetrates the seventh insulating layer INS7. The eighth insulating layer INS8 may be disposed on the first connection wiring CNL1 and the second connection wiring CNL2.

The first bridge pattern BRP1 and the second bridge pattern BRP2 may be disposed on the eighth insulating layer INS8. The first bridge pattern BRP1 and the second bridge pattern BRP2 may be included in the seventh conductive layer CL7. The seventh conductive layer CL7 may include the same material as that of the second conductive layer CL2 or the fifth conductive layer CL5 or may include one or more materials appropriate (or selected) from the materials exemplified as the material of the second conductive layer CL2 or the fifth conductive layer CL5. The first bridge pattern BRP1 may be electrically connected to the first connection wiring CNL1 through a second via hole VIH2 which penetrates the eighth insulating layer INS8. The second bridge pattern BRP2 may be electrically connected to the second connection wiring CNL2 through another second via hole VIH2 which penetrates the eighth insulating layer INS8. The ninth insulating layer INS9 may be disposed on the first and second bridge patterns BRP1, BRP2.

A display element layer DPL may be disposed on the pixel circuit layer PCL of the subpixel SPX, and a sensor layer SSL may be disposed on the pixel circuit layer PCL of the light-sensing pixel PSR.

The light-emitting element LED and a bank BNK may be disposed in the display element layer DPL. The light-emitting element LED may include an anode electrode AE (or a pixel electrode), a light-emitting layer EML, and a cathode electrode CE (or a common electrode). The light-emitting element LED may be electrically connected to the sixth transistor T6 through the first bridge pattern BRP1 and the first connection wiring CNL1. The light-emitting layer EML may include a hole transport layer, an organic material layer (or a photogenic layer), an electron transport layer, or the like.

The light-receiving element LRD and a bank BNK may be disposed in the sensor layer SSL. The light-receiving element LRD may be an optical fingerprint sensor. The light-receiving element LRD may recognize a fingerprint by sensing light reflected by a ridge FR of a finger F and a valley FV between the ridges FR. In an embodiment, when the user's finger F contacts a window WD, first light L1 outputted from the light-emitting element LED (or the light-emitting layer EML) may be reflected by the ridge FR or the valley FV of the finger F, and second light L2 reflected may reach the light-receiving element LRD (or a light-receiving layer OPL) of the sensor layer SSL. The light-receiving element LRD may recognize a pattern of the user fingerprint by distinguishing the second light L2 reflected from the ridge FR of the finger F and the second light L2 reflected from the valley FV of the finger F. The light-receiving element LRD may be electrically connected to the ninth transistor T9. The light-receiving element LRD may include a first electrode EL1 (or a first sensor electrode), a light-receiving layer OPL (or a photoelectric conversion layer), and a second electrode EL2 (or a second sensor electrode).

The anode electrode AE and the first electrode EL1 may be disposed on the ninth insulating layer INS9. The anode electrode AE and the first electrode EL1 may include, but not limited to, a metal layer such as silver, magnesium, aluminum, platinum, palladium, gold, nickel, neodymium, iridium, chromium, and any alloys thereof and/or indium tin oxide (ITO), indium zinc oxide (IZO), zinc oxide (ZnO), indium tin zinc oxide (ITZO) and so on. The anode electrode AE may be electrically connected to the first bridge pattern BRP1 through a third via hole VIH3 which penetrates the ninth insulating layer INS9. The first electrode EL1 may be electrically connected to the second bridge pattern BRP2 through another third via hole VIH3 which penetrates the ninth insulating layer INS9.

The anode electrode AE and the first electrode EL1 may be formed at the same time or in sequence through patterning using a mask.

The bank BNK may be a pixel defining layer which defines (or partitions) a light-emitting area EMA of the subpixel SPX and a light-receiving area FXA of the light-sensing pixel PSR. The bank BNK may be an organic film including an organic material (or substance). The organic material may include acrylic resin, epoxy resin, phenolic resin, polyamide resin, polyimide resin or the like. The bank BNK may be disposed on the ninth insulating layer INS9 in a non-emission area NEA of the subpixel SPX and the light-sensing pixel PSR.

In embodiments, the bank BNK may include a light absorbing material, or a light absorbent may be spread to absorb light incident from outside. In an embodiment, the bank BNK may include, but not limited to, a carbon-based black pigment, for example. The bank BNK may also include an opaque metallic material such as chromium, molybdenum, an alloy of molybdenum and titanium, tungsten, vanadium, niobium, tantalum, manganese, cobalt, or nickel with a relatively high light absorption rate. The bank BNK may define openings corresponding to the light-emitting area EMA and the light-receiving area FXA.

The light-emitting layer EML may be disposed on the anode electrode AE. The light-emitting layer EML may include an organic light-emitting layer. Depending on the organic material included in the light-emitting layer EML, the light-emitting layer EML may emit light such as red light, green light, or blue light, but is not limited thereto.

The light-receiving layer OPL may be disposed on the first electrode EL1. The light-receiving layer OPL may detect the intensity of the light by emitting electrons in response to light of a predetermined wavelength band.

The light-receiving layer OPL may include a relatively low molecular organic substance (or material). In an embodiment, the light-receiving layer OPL includes a phthalocyanine compound including one or more metals selected from a group including cupper (Cu), iron (Fe), nickel (Ni), cobalt (Co), manganese (Mn), aluminum (Al), palladium (Pd), tin (Sn), indium (In), lead (Pb), titanium (Ti), rubidium (Rb), vanadium (V), gallium (Ga), terbium (Tb), cerium (Ce), lanthanum (La), and zinc (Zn), for example.

In an alternative embodiment, the relatively low molecular organic material included in the light-receiving layer OPL may include a bi-layer including a layer which includes a phthalocyanine compound including one or more metals selected from the group including cupper (Cu), iron (Fe), nickel (Ni), cobalt (Co), manganese (Mn), aluminum (Al), palladium (Pd), tin (Sn), indium (In), lead (Pb), titanium (Ti), rubidium (Rb), vanadium (V), gallium (Ga), terbium (Tb), cerium (Ce), lanthanum (La), and zinc (Zn) and a layer which includes carbon-60 (C60), or may include a single mixing layer by mixing a phthalocyanine compound and C60. However, it is not limited to the embodiment described above, and the light-receiving layer OPL may include a polymer organic layer in embodiments.

The cathode electrode CE may be disposed on the light-emitting layer EML, and the second electrode EL2 may be disposed on the light-receiving layer OPL. The cathode electrode CE and the second electrode EL2 may be common electrodes unitary in the display area DA. The second power voltage (refer to VSS of FIG. 5) may be supplied to the cathode electrode CE and the second electrode EL2.

The cathode electrode CE and the second electrode EL2 may include a metal layer such as Ag, Mg, Al, Pt, Pd, Au, Ni, Nd, Ir, or Cr, and/or a transparent conductive layer such as ITO, IZO, ZnO, or ITZO. In embodiments, the cathode electrode CE and the second electrode EL2 may include a multi-layer of two or more layers including a metal thin film layer, e.g., a tri-layer of ITO/Ag/ITO.

A thin film encapsulation layer TFL may be formed on an entirety of the cathode electrode CE and the second electrode EL2.

The thin film encapsulation layer TFL may include a single layer, but may also include a multi-layer. The thin film encapsulation layer TFL may include a plurality of insulating layers for covering the light-emitting element LED and the light-receiving element LRD. Specifically, the thin film encapsulation layer TFL may include at least one inorganic film and at least one organic film. In an embodiment, the thin film encapsulation layer TFL may have a structure in which an inorganic film and an organic film are alternately stacked, for example.

A color filter layer CFL may be disposed on the thin encapsulation layer TFL. The color filter layer CFL may include a light-blocking pattern and a color filter. The light-blocking pattern may be disposed on the thin film encapsulation layer TFL to correspond to the light-emitting area EMA of the subpixel SPX and the non-emission area NEA surrounding the light-receiving area FXA of the light-sensing pixel PSR, and the color filter may be disposed on the thin film encapsulation layer TFL to correspond to the light-emitting area EMA and the light-receiving area FXA, which are not limited thereto. In embodiments, the color filter may be omitted. The color filter layer CFL mentioned above may also be used as an anti-reflection layer for blocking external light reflection.

The window WD may be disposed on the color filter layer CFL.

The window WD may protect an exposed surface of the display device 1 (or the display panel (refer to 100 of FIG. 1)). The window WD may protect the display device 1 from external shock, and provide the user with an input surface and/or a display surface. The window WD (or a cover glass) may have a multi-layer structure selected from a glass substrate, a plastic film, and a plastic substrate. Such a multi-layer structure may be formed through a continuous process or an adhesion process using an adhesive layer. The window WD may have flexibility in whole or in part.

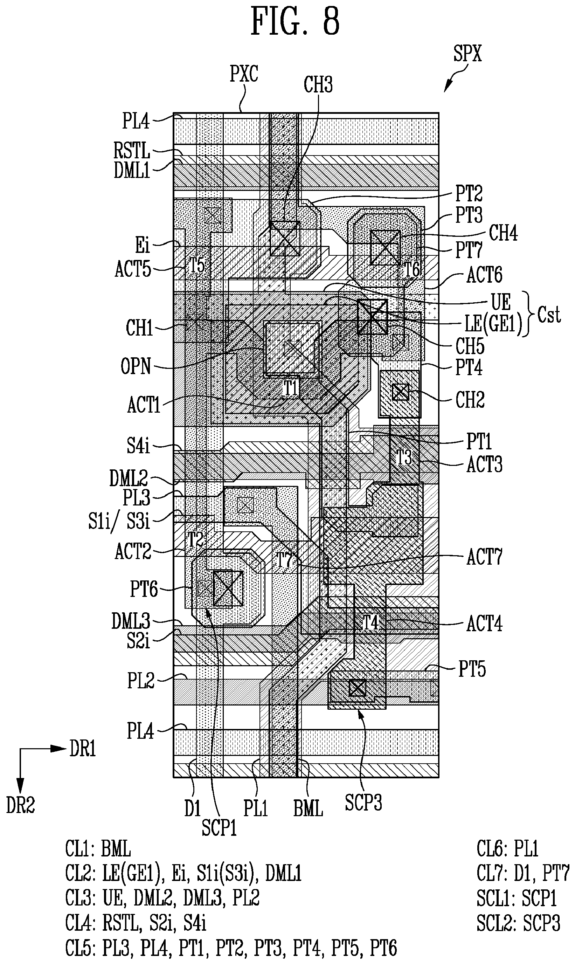

FIG. 8 is a schematic plan view illustrating an embodiment of a subpixel SPX.

In FIG. 8, a subpixel SPX disposed on the i-th horizontal line (or the i-th pixel row) and connected to the first data line D1 is depicted to ease the explanation.

Referring to FIG. 4 and FIG. 8, the subpixel SPX may include the pixel circuit PXC. Signal wiring may be disposed in the display area (refer to DA of FIG. 1) where the subpixel SPX is disposed. In an embodiment, the 1i-th through 4i-th scan lines S1i through S4i, the i-th emission control line Ei, the reset line RSTL, the first through fourth power wiring PL1 through PL4, and the first data line D1 may be disposed in the display area DA, for example.

The 1i-th scan line S1i may be included in the second conductive layer CL2, and may be extended in the first direction DR1. The first scan signal (refer to GW[i] of FIG. 5) may be supplied to the 1i-th scan line S1i. In embodiments, the third scan signal (refer to GB[i] of FIG. 5) may be selectively supplied to the 1i-th scan line S1i. The 1i-th scan line S1i may be the 3i-th scan line S3i. One area of the 1i-th scan line S1i may be the gate electrode (hereinafter, also referred to as a "second gate electrode") of the second transistor T2 of the pixel circuit PXC. Another area of the 1i-th scan line S1i may be the gate electrode (hereinafter, also referred to as a "seventh gate electrode") of the seventh transistor T7 of the pixel circuit PXC.

The 2i-th scan line S2i may be included in the fourth conductive layer CL4, and may be extended in the first direction DR1. The 2i-th scan line S2i may be supplied with the second scan signal (refer to GI[i] of FIG. 5). One area of the 2i-th scan line S2i may be the gate electrode (hereinafter, referred to a "fourth gate electrode") of the fourth transistor T4.

The 4i-th scan line S4i may be extended in the first direction DR1, and may be included in the fourth conductive layer CL4. The 4i-th scan line S4i may be spaced apart from the 2i-th scan line S2i disposed in the same layer. The 4i-th scan line S4i may be supplied with the fourth scan signal (refer to GC[i] of FIG. 5). One area of the 4i-th scan line S4i may be the gate electrode (hereinafter, also referred to as a "third gate electrode") of the third transistor T3.

The i-th emission control line Ei may be extended in the first direction DR1, and may be included in the second conductive layer CL2. The i-th emission control line Ei may be spaced from the 1i-th scan line S1i. The i-th emission control line Ei may be supplied with the emission control signal (refer to EM[i] of FIG. 5). One area of the i-th emission control line Ei may be the gate electrode (hereinafter, also referred to as a "fifth gate electrode") of the fifth transistor T5. Another area of the i-th emission control line Ei may be the gate electrode (hereinafter, also referred to as a "sixth gate electrode") of the sixth transistor T6.

The reset line RSTL may be extended in the first direction DR1, and may be included in the fourth conductive layer CL4. The reset line RSTL may be spaced apart from the 2i-th scan line S2i and the 4i-th scan line S4i. The reset line RSTL may be supplied with the reset signal (refer to RST of FIG. 5).

The first power wiring PL1 may be extended in the second direction DR2 intersecting the first direction DR1, and may include the sixth conductive layer CL6. The first power wiring PL1 may be supplied with the first power voltage (refer to VDD of FIG. 5). The first power wiring PL1 may be electrically connected to the second pattern PT2 through the corresponding third contact hole CH3. The second pattern PT2 may be included in the fifth conductive layer CL5, and may be electrically connected to the first semiconductor pattern SCP1 of the fifth transistor T5 through the corresponding first contact hole CH1. In other words, the first power wiring PL1 may be electrically connected to the first semiconductor pattern SCP1 of the fifth transistor T5 through the second pattern PT2.

The second power wiring PL2 may be extended in the first direction DR1, and may be included in the third conductive layer CL3. The second power wiring PL2 may be supplied with the first initialization power voltage (refer to Vint1 of FIG. 5). The second power wiring PL2 may be electrically connected to the fifth pattern PT5 through the corresponding second contact hole CH2. The fifth pattern PT5 may be included in the fifth conductive layer CL5, and may be electrically connected to the second semiconductor pattern SCP2 of the fourth transistor T4 through the corresponding first contact hole CH1. In other words, the second power wiring PL2 may be electrically connected to the third semiconductor pattern SCP3 of the fourth transistor T4 through the fifth pattern PT5.

The third power wiring PL3 may be extended in the first direction DR1, and may be included in the fifth conductive layer CL5. The third power wiring PL3 may be supplied with the second initialization power voltage (refer to Vint2 of FIG. 5). The third power wiring PL3 may be electrically connected to the first semiconductor pattern SCP1 of the seventh transistor T7 through the corresponding first contact hole CH1.

The fourth power wiring PL4 may be extended in the first direction DR1, and may be included in the fifth conductive layer CL5. The fourth power wiring PL4 may be spaced away from the third power wiring PL3. The fourth power wiring PL4 may be supplied with the reset voltage (refer to VRST of FIG. 5).

The first data line D1 may be extended in the second direction DR2, and may be included in the seventh conductive layer CL7. The first data line D1 may be supplied with the data signal. The first data line D1 may be electrically connected to the sixth pattern PT6 through the corresponding fourth contact hole CH4. The sixth pattern PT6 may be included in the fifth conductive layer CL5, and may be electrically connected to the first semiconductor pattern SCP1 of the second transistor T2 through the corresponding first contact hole CH1. In other words, the first data line D1 may be electrically connected to the first semiconductor pattern SCP1 of the second transistor T2 through the sixth pattern PT6.

Other signal wiring than the above-described signal wiring may be disposed in the display area DA where the subpixel SPX is disposed. In an embodiment, a first dummy line DML1, a second dummy line DML2, and a third dummy line DML3 may be disposed in the display area DA, for example.

The first dummy line DML1 may extend in the first direction DR1, and be included in the second conductive layer CL2. The first dummy line DML1 may overlap with the reset line RSTL. In embodiments, the first dummy line DML1 may be electrically connected to the reset line RSTL to implement a bi-layer structure with the reset line RSTL, thus reducing wiring resistance of the reset line RSTL.

The second dummy line DML2 may be extended in the first direction DR1, and may be included in the third conductive layer CL3. The second dummy line DML2 may overlap with the 4i-th scan line S4i. In embodiments, the second dummy line DML2 may be electrically connected to the 4i-th scan line S4i to implement a bi-layer structure with the 4i-th scan line S4i, thus reducing wiring resistance of the 4i-th scan line S4i.

The third dummy line DML3 may extend in the first direction DR1, and be included in the third conductive layer CL3. The third dummy line DML3 may overlap with the 2i-th scan line S2i. In embodiments, the third dummy line DML3 may be electrically connected to the 2i-th scan line S2i to implement a bi-layer structure with the 2i-th scan line S2i, thus reducing wiring resistance of the 2i-th scan line S2i.

The pixel circuit PXC may include the first, second, third, fourth, fifth, sixth, and seventh transistors T1, T2, T3, T4, T5, T6, T7 and the storage capacitor Cst.

The first transistor T1 may include a first active pattern ACT1 and a first gate electrode GE1.

The first active pattern ACT1 may be an area of the first semiconductor pattern SCP1 which overlaps with the first gate electrode GE1. The first semiconductor pattern SCP1 may be the first semiconductor layer (refer to SCL1 of FIG. 6). The first active pattern ACT1 may be the channel area of the first transistor T1.

The channel area is a semiconductor pattern not doped with an impurity, and may be an intrinsic semiconductor, for example. The rest area of the semiconductor pattern excluding the channel area may be a semiconductor pattern doped with an impurity.

One area of the first semiconductor pattern SCP1 which does not overlap with the first gate electrode GE1 and is connected to one side (e.g., a left side of the first active pattern ACT1 in the plan view) of the first active pattern ACT1 (or the channel area) may be a first contact area. One area of the first semiconductor pattern SCP1 which does not overlap with the first gate electrode GE1 and is connected to a side (e.g., a right side of the first active pattern ACT1 in the plan view) opposite to the one side of the first active pattern ACT1 may be a second contact area. The first contact area and the second contact area may extend in opposite directions from the first active pattern ACT1. The first contact area may be connected to one side of the first active pattern ACT1, the first semiconductor pattern SCP1 of the second transistor T2 and the first semiconductor pattern SCP1 of the fifth transistor T5. The second contact area may be connected to a side opposite the one side of the first active pattern ACT1, and connected to the first semiconductor pattern SCP1 of the sixth transistor T6.

The first gate electrode GE1 may overlap with the first active pattern ACT1, and be included in the second conductive layer CL2. The first gate electrode GE1 may be an island-shaped conductive pattern. The first gate electrode GE1 may be electrically connected to an area of the third semiconductor pattern SCP3 shared by the third transistor T3 and the fourth transistor T4 through the first pattern PT1.

The first pattern PT1 may be included in the fifth conductive layer CL5. One end of the first pattern PT1 may be electrically connected to the first gate electrode GE1 through the corresponding first contact hole CH1. An opposite end of the first pattern PT1 may be electrically connected to an area of the third semiconductor pattern SCP3 shared by the third transistor T3 and the fourth transistor T4 through the corresponding second contact hole CH2.

The first gate electrode GE1 may overlap with the lower metal pattern BML.

The lower metal pattern BML may be included in the first conductive layer CL1, and overlap with the first transistor T1 (or the storage capacitor Cst). The lower metal pattern BML may shield the first transistor T1 (or the storage capacitor Cst) from below. A constant voltage (e.g., the first power voltage VDD) may be applied to the lower metal pattern BML, but is not limited thereto. The lower metal pattern BML may be extended in the first direction DR1 and second direction DR2 based on the first transistor T1. The lower metal pattern BML may have a mesh structure across the display area DA.

The second transistor T2 may include a second active pattern ACT2 and a second gate electrode.

The second active pattern ACT2 may be an area of the first semiconductor pattern SCP1 which overlaps with the 1i-th scan line S1i. The second active pattern ACT2 may be the channel area of the second transistor T2.

One area of the first semiconductor pattern SCP1 which does not overlap with the 1i-th scan line S1i and is connected to one side of the second active pattern ACT2 (e.g., a lower side of the second active pattern ACT2 in the plan view) may be a first contact area, and one area of the first semiconductor pattern SCP1 which does not overlap with the 1i-th scan line S1i and is connected to a side opposite to the one side of the second active pattern ACT2 (e.g., an upper side of the second active pattern ACT2 in the plan view) may be a second contact area. The first contact area may be connected to one side of the second active pattern ACT2, and may be electrically connected to the sixth pattern PT6. The second contact area may be connected to an opposite side of the second active pattern ACT2, and connected to the first contact area of the first transistor T1.

The second gate electrode may be an area of the 1i-th scan line S1i which overlaps with the second active pattern ACT2.

The third transistor T3 may include a third active pattern ACT3 and a third gate electrode.

The third active pattern ACT3 is an area of the third semiconductor pattern SCP3 overlapping with the 4i-th scan line S4i, and may configure the channel area of the third transistor T3. The third semiconductor pattern SCP3 may include the second semiconductor layer SCL2.

One area of the third semiconductor pattern SCP3 which does not overlap with the 4i-th scan line S4i and is connected to one side of the third active pattern ACT3 (e.g., an upper side of the third active pattern ACT3 in the plan view) may be the first contact area, and one area of the third semiconductor pattern SCP3 which does not overlap with the 4i-th scan line S4i and is connected to an opposite side of the third active pattern ACT3 (e.g., a lower side of the third active pattern ACT3 in the plan view) may be the second contact area. The first contact area may be connected to one side of the third active pattern ACT3, and may be electrically connected to the first transistor T1 and the sixth transistor T6 through the fourth pattern PT4. The second contact area may be connected to an opposite side of the third active pattern ACT3, and may be connected to the third semiconductor pattern SCP3 of the fourth transistor T4.

The fourth pattern PT4 may be included in the fifth conductive layer CL5. One end of the fourth pattern PT4 may be electrically connected to the first semiconductor pattern SCP1 shared by the first transistor T1 and the sixth transistor T6 through the corresponding first contact hole CH1. An opposite end of the fourth pattern PT4 may be electrically connected to the first contact area of the third transistor T3 through the corresponding second contact hole CH2.

The third gate electrode may be an area of the 4i-th scan line S4i overlapping with the third active pattern ACT3.

The fourth transistor T4 may include a fourth active pattern ACT4 and a fourth gate electrode.

The fourth active pattern ACT4 is an area of the third semiconductor pattern SCP3 overlapping with the 2i-th scan line S2i, and may configure the channel area of the fourth transistor T4.

One area of the third semiconductor pattern SCP3 which does not overlap with the 2i-th scan line S2i and is connected to one side of the fourth active pattern ACT4 (e.g., an upper side of the fourth active pattern ACT4 in the plan view) may be the first contact area, and one area of the third semiconductor pattern SCP3 which does not overlap with the 2i-th scan line S2i and is connected to an opposite side of the fourth active pattern ACT4 (e.g., a lower side of the fourth active pattern ACT4 in the plan view) may be the second contact area. The first contact area may be connected to one side of the fourth active pattern ACT4, and may be connected to the third semiconductor pattern SCP3 of the third transistor T3. The second contact area may be connected to an opposite side of the fourth active pattern ACT4, and may be electrically connected to the fifth pattern PT5.

The fourth gate electrode may be an area of the 2i-th scan line S2i overlapping with the fourth active pattern ACT4.

The fifth transistor T5 may include a fifth active pattern ACT5 and a fifth gate electrode.

The fifth active pattern ACT5 is an area of the first semiconductor pattern SCP1 overlapping with the i-th emission control line Ei, and may configure the channel area of the fifth transistor T5. The first semiconductor pattern SCP1 may include the first semiconductor layer SCL1.

One area of the first semiconductor pattern SCP1 which does not overlap with the i-th emission control line Ei and is connected to one side of the fifth active pattern ACT5 (e.g., an upper side of the fifth active pattern ACT5 in the plan view) may be the first contact area, and one area of the first semiconductor pattern SCP1 which does not overlap with the i-th emission control line Ei and is connected to an opposite side of the fifth active pattern ACT5 (e.g., a lower side of the fifth active pattern ACT5 in the plan view) may be the second contact area. The first contact area may be connected to one side of the fifth active pattern ACT5, and may be electrically connected to the second pattern PT2. The second contact area may be connected to an opposite side of the fifth active pattern ACT5 and may be connected to the first semiconductor pattern SCP1 of each of the first and second transistors T1, T2.

The fifth gate electrode may be an area of the i-th emission control line Ei overlapping with the fifth active pattern ACT5.

The sixth transistor T6 may include a sixth active pattern ACT6 and a sixth gate electrode.

The sixth active pattern ACT6 is an area of the first semiconductor pattern SCP1 overlapping with the i-th emission control line Ei, and may be the channel area of the sixth transistor T6.

One area of the first semiconductor pattern SCP1 which does not overlap with the i-th emission control line Ei and is connected to one side of the sixth active pattern ACT6 (e.g., an upper side of the sixth active pattern ACT6 in the plan view) may be the first contact area, and one area of the first semiconductor pattern SCP1 which does not overlap with the i-th emission control line Ei and is connected to an opposite side of the sixth active pattern ACT6 (e.g., a lower side of the sixth active pattern ACT6 in the plan view) may be the second contact area. The first contact area may be connected to each of the one side of the sixth active pattern ACT6 and the third pattern PT3. The second contact area may be connected to each of an opposite side of the sixth active pattern ACT6 and the fourth pattern PT4.

The third pattern PT3 may be included in the fifth conductive layer CL5. One end of the third pattern PT3 may be electrically connected to the first semiconductor pattern SCP1 shared by the sixth transistor T6 and the seventh transistor T7 through the corresponding first contact hole CH1. An opposite end of the third pattern PT3 may be electrically connected to the seventh pattern PT7 through the corresponding fourth contact hole CH4.

The seventh pattern PT7 may be included in the seventh conductive layer CL7. One end of the seventh pattern PT7 may be electrically connected to each of the sixth and seventh transistors T6 and T7 through the third pattern PT3. An opposite end of the seventh pattern PT7 may be electrically connected to the anode electrode (refer to AE of FIG. 6) of the light-emitting element (refer to LED of FIG. 6) through the corresponding fifth contact hole CH5. The fifth contact hole CH5 may correspond to the third via hole VIH3 described with reference to FIG. 6.

The sixth gate electrode may be an area of the i-th emission control line Ei overlapping with the sixth active pattern ACT6.

The seventh transistor T7 may include a seventh active pattern ACT7 and a seventh gate electrode.

The seventh active pattern ACT7 may be an area of the first semiconductor pattern SCP1 overlapping with the 1i-th scan line S1i. The first semiconductor pattern SCP1 may include the first semiconductor layer SCL1. The seventh active pattern ACT7 may be the channel area of the seventh transistor T7.

One area of the first semiconductor pattern SCP1 which does not overlap with the 1i-th scan line S1i and is connected to one side of the seventh active pattern ACT7 (e.g., a lower side of the seventh active pattern ACT7 in the plan view) may be the first contact area, and one area of the first semiconductor pattern SCP1 which does not overlap with the 1i-th scan line S1i and is connected to an opposite side (e.g., an upper side of the seventh active pattern ACT7 in the plan view) of the seventh active pattern ACT7 may be the second contact area. The first contact area may be connected to one side of the seventh active pattern ACT7, connected to the first semiconductor pattern SCP1 of the sixth transistor T6, and electrically connected to the third pattern PT3. The second contact area may be connected to an opposite side of the seventh active pattern ACT7, and may be electrically connected to the third power wiring PL3.

The storage capacitor Cst may include a lower electrode LE and an upper electrode UE.

The lower electrode LE may be integrated with the first gate electrode GE1. The lower electrode LE may be included in the second conductive layer CL2.

The upper electrode UE may overlap with the lower electrode LE and be included in the third conductive layer CL3. The upper electrode UE may define an opening OPN with a part thereof removed. An area of the lower electrode LE overlapping with the upper electrode UE may be exposed by the opening OPN. The upper electrode UE may be electrically connected to the second pattern PT2 through the corresponding first contact hole CH1.

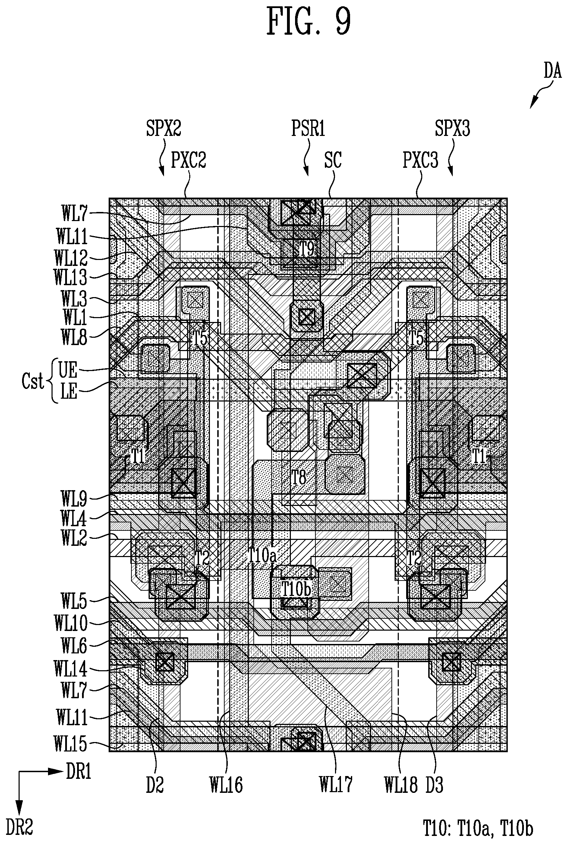

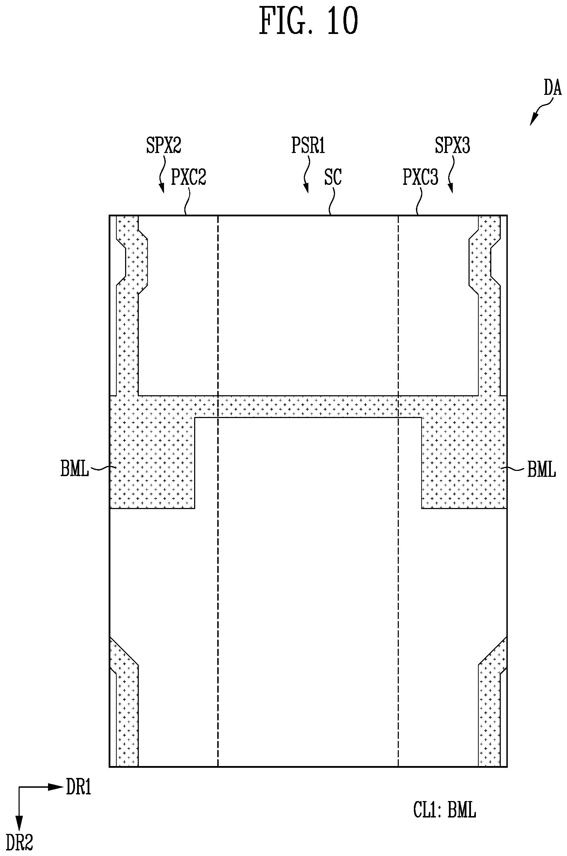

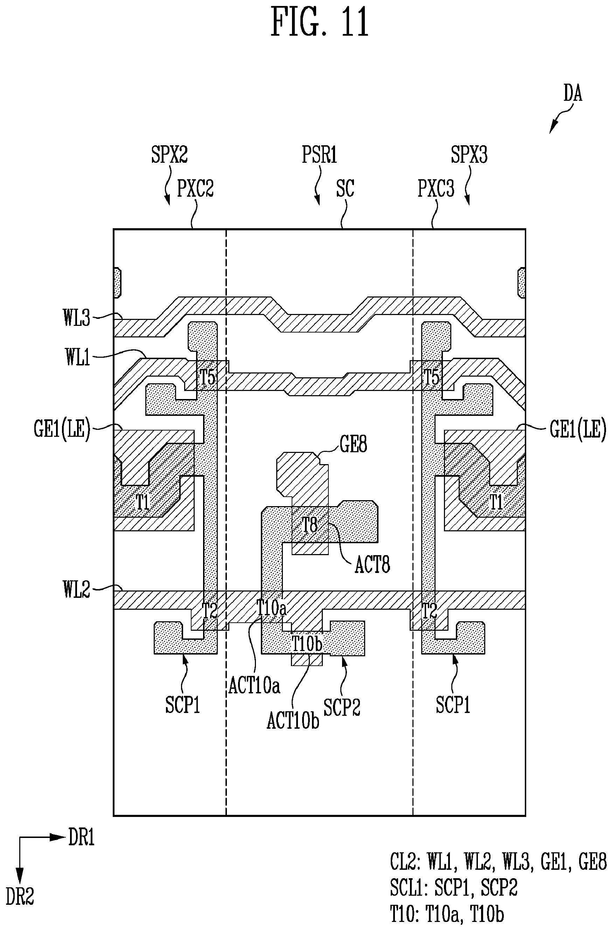

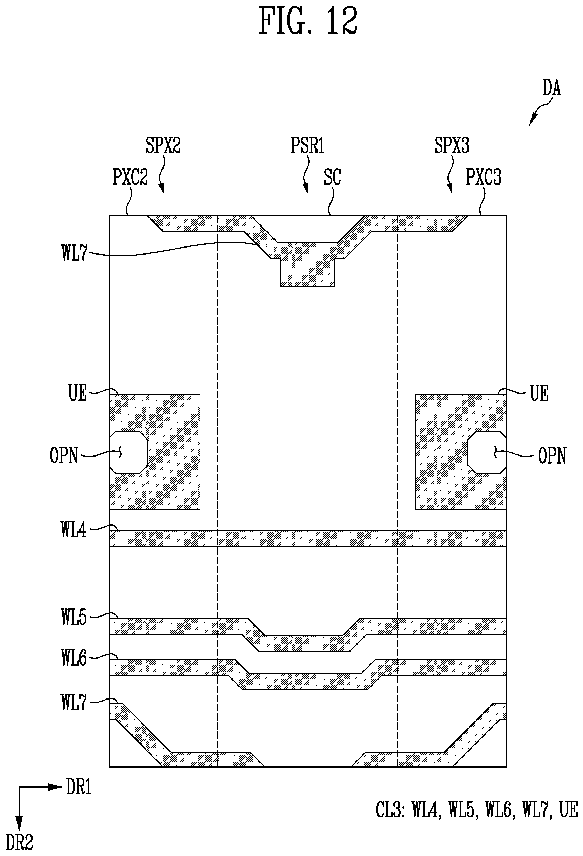

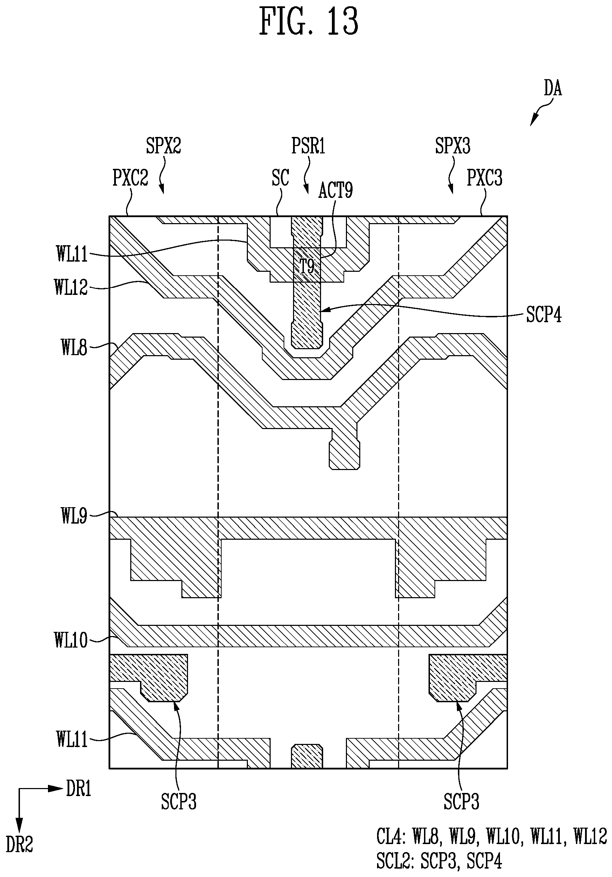

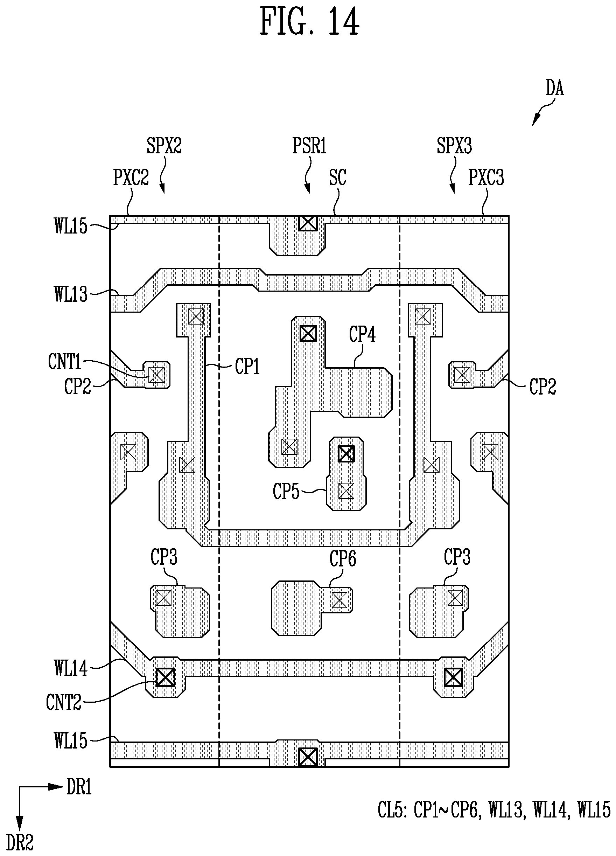

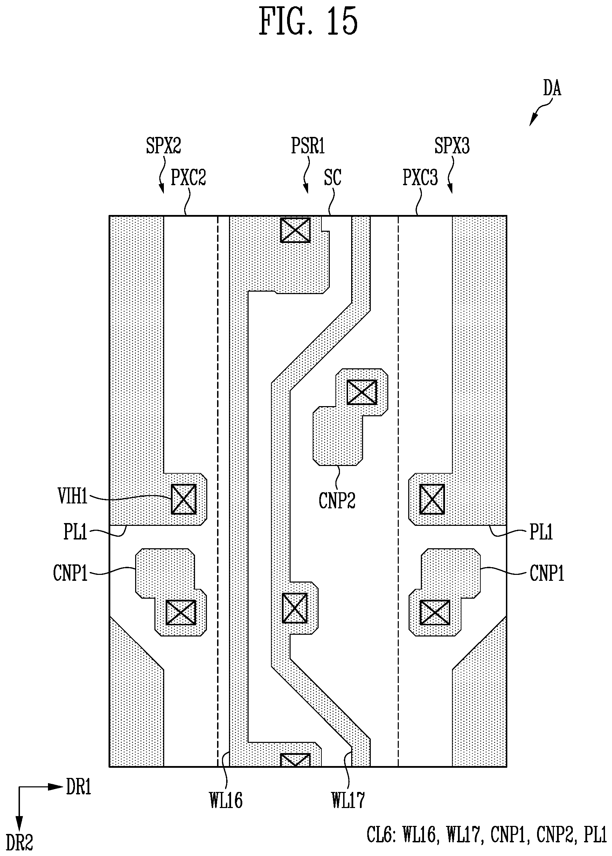

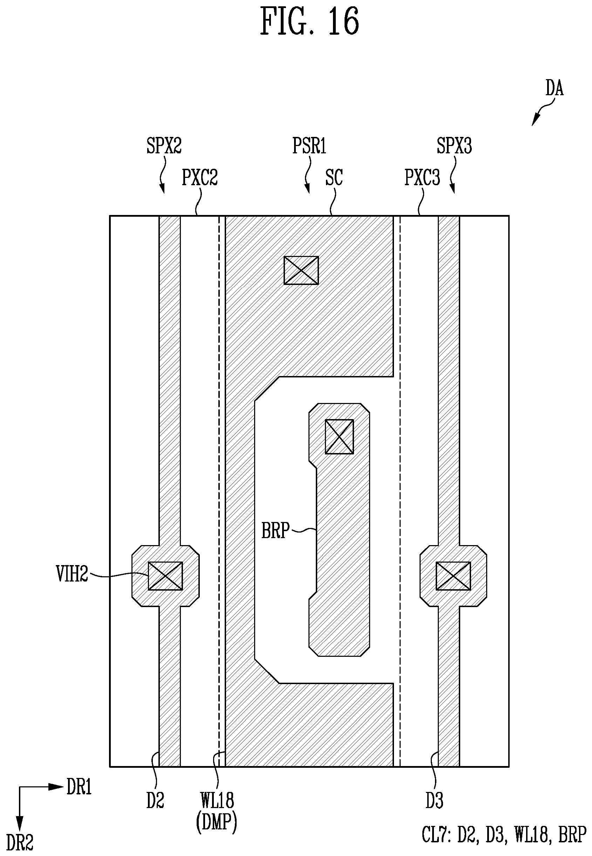

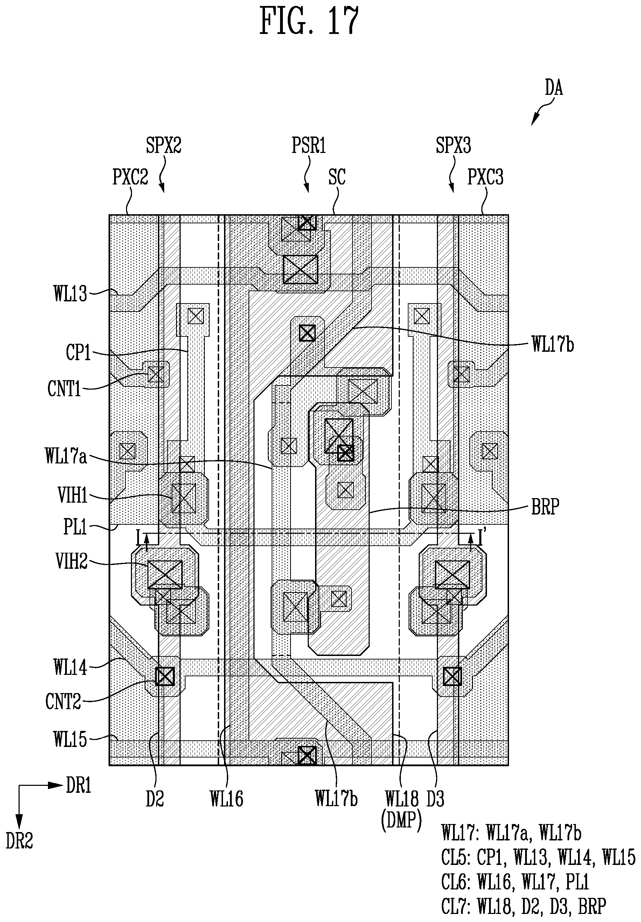

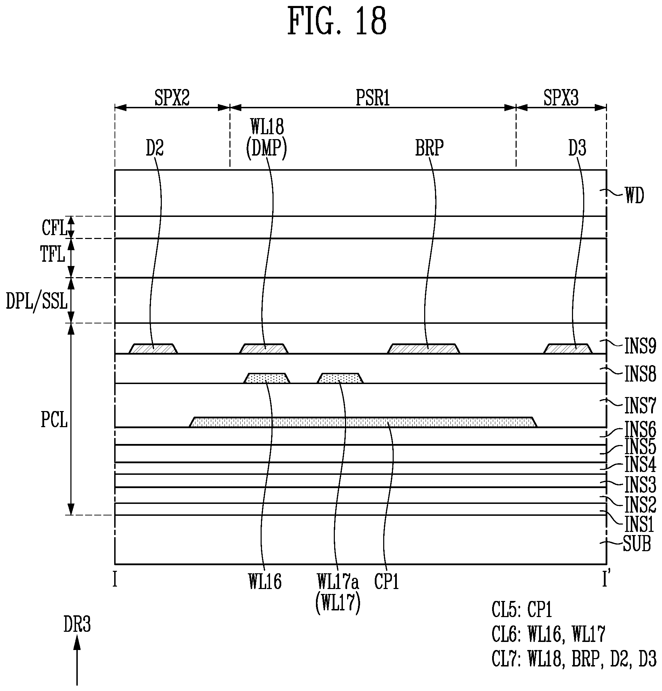

FIG. 9 is a schematic plan view illustrating an embodiment of subpixels SPX and a first light-sensing pixel PSR1, FIG. 10 is a schematic plan view illustrating only configurations included in the first conductive layer CL1 in FIGS. 8 and 9, FIG. 11 is a schematic plan view illustrating only configurations included in the first semiconductor layer SCL1 and the second conductive layer CL2 in FIGS. 8 and 9, FIG. 12 is a schematic plan view illustrating only configurations included in the third conductive layer CL3 in FIGS. 8 and 9, FIG. 13 is a schematic plan view illustrating only configurations included in the second semiconductor layer SCL2 and the fourth conductive layer CL4 in FIGS. 8 and 9, FIG. 14 is a schematic plan view illustrating only configurations included in the fifth conductive layer CL5 in FIGS. 8 and 9, FIG. 15 is a schematic plan view illustrating only configurations included in the sixth conductive layer CL6 in FIG. 9, FIG. 16 is a schematic plan view illustrating only configurations included in the seventh conductive layer CL7 in FIG. 9, FIG. 17 is a schematic plan view illustrating only configurations included in the fifth conductive layer CL5, the sixth conductive layer CL6, and the seventh conductive layer CL7 in FIG. 9, and FIG. 18 is a schematic cross-sectional diagram along line I-I' of FIG. 17.

FIG. 9 through FIG.18 show the second subpixel SPX2, the third subpixel SPX3, and the first light-sensing pixel PSR1 arranged in the same pixel row (or the same horizontal line) for ease of explanation.

Referring to FIG. 1 through FIG. 18, the second subpixel SPX2 and the third subpixel SPX3 may be arranged along the first direction DR1 in the display area DA. The first light-sensing pixel PSR1 may be disposed between the second subpixel SPX2 and the third subpixel SPX3.

The second subpixel SPX2 may include the second pixel circuit PXC2, and the third subpixel SPX3 may include the third pixel circuit PXC3. The first light-sensing pixel PSR1 may include the sensor circuit SC. The second pixel circuit PXC2 may correspond to the second pixel circuit (also referred to as a twelfth pixel circuit) PXC12 of the first pixel row R1 of FIG. 4, the third pixel circuit PXC3 may correspond to the third pixel circuit PXC13 (also referred to as a thirteenth pixel circuit) of the first pixel row R1 of FIG. 4, and the sensor circuit SC may correspond to the first sensor circuit (also referred to as a eleventh sensor circuit) SC11 of FIG. 4. Based on the sensor circuit SC, the second pixel circuit PXC2 disposed on the left and the third pixel circuit PXC3 disposed on the right may be mirror symmetrical and substantially identical. For convenience, FIG. 9 through FIG. 18 show a part of the second pixel circuit PXC2 and a part of the third pixel circuit PXC3 disposed on the left and the right of the sensor circuit SC, respectively.

The second and third subpixels SPX2, SPX3 may include the substrate SUB, the pixel circuit layer PCL, the display element layer DPL, the thin film encapsulation layer TFL, the color filter layer CFL, and the window WD. The first light-sensing pixel PSR1 may include the substrate SUB, the pixel circuit layer PCL, the sensor layer SSL, the thin film encapsulation layer TFL, the color filter layer CFL, and the window WD.

The substrate SUB may include a transparent insulation material to allow the light to pass through. The substrate SUB may be a rigid substrate or a flexible substrate.

The second and third pixel circuits PXC2 and PXC3, the sensor circuit SC, and signal wiring may be disposed in the pixel circuit layer PCL. The second and third pixel circuits PXC2, PXC3 each may include the first transistor T1, the second transistor T2, the third transistor (refer to T3 of FIG. 8), the fourth transistor (refer to T4 of FIG. 8), the fifth transistor T5, the sixth transistor (refer to T6 of FIG. 8), the seventh transistor (refer to T7 of FIG. 8), and the storage capacitor Cst.

In the display element layer DPL, the light-emitting element (refer to LED of FIG. 7) electrically connected to each of the second and third pixel circuits PXC2 and PXC3 may be disposed. In the sensor layer SSL, the light-receiving element (refer to LRD of FIG. 7) electrically connected to the sensor circuit SC may be disposed.

In the pixel circuit layer PCL, the first insulating layer INS1, the second insulating layer INS2, the third insulating layer INS3, the fourth insulating layer INS4, the fifth insulating layer INS5, the sixth insulating layer INS6, the seventh insulating layer INS7, the eighth insulating layer INS8, and the ninth insulating layer INS9 stacked sequentially from one surface of the substrate SUB along the third direction DR3 may be disposed.

The pixel circuit layer PCL may include at least one or more conductive layers and at least one or more semiconductor layers. In an embodiment, the pixel circuit layer PCL may be included in the first conductive layer CL1),the first semiconductor layer SCL1, the second conductive layer CL2, the third conductive layer CL3, the second semiconductor layer SCL2, the fourth conductive layer CL4, the fifth conductive layer CL5, the sixth conductive layer CL6, and the seventh conductive layer CL7 stacked sequentially from one surface of the substrate SUB along the third direction DR3, for example.

The signal wiring may be disposed in the display area DA where the second and third subpixels SPX2 and SPX3 and the first light-sensing pixel PSR1 are disposed. In an embodiment, the display area DA may include the first through eighteen wiring WL1 through WL18, the second and third data lines D2, D3, and the first power wiring PL1, for example.

The first wiring WL1 may extend in the first direction DR1, and be included in the second conductive layer CL2. The first wiring WL1 may be the i-th emission control line Ei described with reference to FIG. 8. One area of the first wiring WL1 may be the gate electrode of the fifth transistor T5 of each of the second and third pixel circuits PXC2, PXC3.

The second wiring WL2 may extend in the first direction DR1, and may be disposed apart from the first wiring WL1. The second wiring WL2 may be included in the second conductive layer CL2. The second wiring WL2 may be the 1i-th scan line S1i described with reference to FIG. 8. One area of the second wiring WL2 may be the gate electrode of the second transistor T2 of each of the second and third pixel circuits PXC2, PXC3. Another area of second wiring WL2 may be a gate electrode (hereinafter, also referred to as a "10a-th gate electrode") of a 10a-th transistor T10a of the sensor circuit SC. A protrusion of the second wiring WL2 may be a gate electrode (hereinafter, also referred to as a "10b-th gate electrode") of a 10b-th transistor T10b of the sensor circuit SC.

The third wiring WL3 may extend in the first direction DR1, and may be disposed apart from the first and second wiring WL1, WL2. The third wiring WL3 may be included in the second conductive layer CL2. The third wiring WL3 may be the first dummy line DML1 described with reference to FIG. 8.

The fourth wiring WL4 may extend in the first direction DR1, and be included in the third conductive layer CL3. The fourth wiring WL4 may be the second dummy line DML2 described with reference to FIG. 8. The fourth wiring WL4 may overlap with the ninth wiring WL9 included in the fourth conductive layer CL4. In an embodiment, the fourth wiring WL4 may be electrically connected to the ninth wiring WL9 to implement the bi-layer structure with the ninth wiring WL9, thus reducing wiring resistance of the ninth wiring WL9.

The fifth wiring WL5 may extend in the first direction DR1, and be included in the third conductive layer CL3. The fifth wiring WL5 may be disposed apart from the fourth wiring WL4. The fifth wiring WL5 may be the third dummy line DML3 described with reference to FIG. 8. The fifth wiring WL5 may overlap with the tenth wiring WL10 included in the fourth conductive layer CL4. In embodiments, the fifth wiring WL5 may be electrically connected to the tenth wiring WL10 to implement the bi-layer structure with the tenth wiring WL10, thus reducing wiring resistance of the tenth wiring WL10.

The sixth wiring WL6 may extend in the first direction DR1, and be included in the third conductive layer CL3. The sixth wiring WL6 may be disposed apart from the fourth and fifth wiring WL4, WL5. The sixth wiring WL6 may be, but not limited to, a dummy line which overlaps with the fourteenth wiring WL14 including the fifth conductive layer CL5.

The seventh wiring WL7 may extend in the first direction DR1, and be included in the third conductive layer CL3. The seventh wiring WL7 may be disposed apart from the fourth through sixth wiring WL4 through WL6. The seventh wiring WL7 may be, but not limited to, a dummy line which overlaps with the eleventh wiring WL11 be included in the fourth conductive layer CL4.

The eighth wiring WL8 may extend in the first direction DR1, and be included in the fourth conductive layer CL4. The eighth wiring WL8 may be the fifth power wiring PL5 described with reference to FIG. 5. The eighth wiring WL8 may be supplied with the common voltage (refer to VCOM of FIG. 5) (or the second initialization power voltage (refer to Vint2 of FIG. 5)). The eighth wiring WL8 may be electrically connected to the sixth conductive pattern CP6 including the fifth conductive layer CL5 through the corresponding second contact CNT2.

The sixth conductive pattern CP6 may include the fifth conductive layer CL5. One end of the sixth conductive pattern CP6 may be electrically connected to the eighth wiring WL8 through the second contact CNT2 penetrating the sixth insulating layer INS6. An opposite end of the sixth conductive pattern CP6 may be electrically connected to the second semiconductor pattern SCP2 of the eighth transistor T8 through the first contact CNT1 which penetrates the sixth insulating layer INS6, the fifth insulating layer INS5, the fourth insulating layer INS4, the third insulating layer INS3, and the second insulating layer INS2.

The ninth wiring WL9 may extend in the first direction DR1, and may be disposed apart from the eighth wiring WL8. The ninth wiring WL9 may be included in the fourth conductive layer CL4. The ninth wiring WL9 may be the 4i-th scan line S4i described with reference to FIG. 8. One area of the ninth wiring WL9 may be the gate electrode of the third transistor T3 of each of the second and third pixel circuits PXC2, PXC3.

The tenth wiring WL10 may extend in the first direction DR1, and may be disposed apart from each of the eighth and ninth wiring WL8, WL9. The tenth wiring WL10 may be included in the fourth conductive layer CL4. The tenth wiring WL10 may be the 2i-th scan line S2i described with reference to FIG. 8. One area of the tenth wiring WL10 may be the gate electrode of the fourth transistor T4 of each of the second and third pixel circuits PXC2, PXC3.

The eleventh wiring WL11 may extend in the first direction DR1, and may be disposed apart from each of the eighth through tenth wiring WL8 through WL10. The eleventh wiring WL11 may be included in the fourth conductive layer CL4. The eleventh wiring WL11 may be the reset line RSTL described with reference to FIG. 8. One area of the eleventh wiring WL11 may be a gate electrode (hereinafter, also referred to as a "ninth gate electrode") of the ninth transistor T9 of the sensor circuit SC.

The twelfth wiring WL12 may be disposed apart from each of the eighth through eleventh wiring WL8 through WL11. The twelfth wiring WL12 may be included in the fourth conductive layer CL4. The twelfth wiring WL12 may be the third power wiring PL3 described with reference to FIG. 5. The twelfth wiring WL12 may be supplied with the second initialization power voltage (refer to Vint2 of FIG. 5) (or the common voltage VCOM). In embodiments, the twelfth wiring WL12 and the eighth wiring WL8 may be supplied with the same voltage.

The thirteenth wiring WL13 may extend in the first direction DR1, and include the fifth conductive layer CL5. The thirteenth wiring WL13 may be, but not limited to, a dummy line supplied with a bias voltage. In embodiments, the thirteenth wiring WL13 may be omitted.

The fourteenth wiring WL14 may extend in the first direction DR1, and include the fifth conductive layer CL5. The fourteenth wiring WL14 may be disposed apart from the thirteenth wiring WL13. The fourteenth wiring WL14 may be the second power wiring PL2 described with reference to FIG. 8. The fourteenth wiring WL14 may be supplied with the first initialization power voltage Vint1. The fourteenth wiring WL14 may be electrically connected to the third semiconductor pattern SCP3 of the fourth transistor T4 of each of the second and third pixel circuits PXC2, PXC3 through the second contact CNT2 which penetrates the sixth insulating layer INS6 and the fifth insulating layer INS5.

The fifteenth wiring WL15 may extend in the first direction DR1, and include the fifth conductive layer CL5. The fifteenth wiring WL15 may be disposed apart from each of the thirteenth and fourteenth wiring WL13, WL14. The fifteenth wiring WL15 may be electrically connected to the fourth semiconductor pattern SCP4 of the ninth transistor T9 of the sensor circuit SC through the second contact CNT2 which penetrates the sixth insulating layer INS6 and the fifth insulating layer INS5.

The sixteenth wiring WL16 may extend in the second direction DR2, and be included in the sixth conductive layer CL6. The sixteenth wiring WL16 may be electrically connected to the fifteenth wiring WL15 through the first via hole VIH1 penetrating the seventh insulating layer INS7. The sixteenth wiring WL16 may be disposed within the first light-sensing pixel PSR1 where the sensor circuit SC is disposed. The sixteenth wiring WL16 may be the fourth power wiring PL4 described with reference to FIG. 8. The sixteenth wiring WL16 may be supplied with the reset voltage (refer to VRST of FIG. 5). The reset voltage VRST may be also supplied to the fifteenth wiring WL15 electrically connected to the sixteenth wiring WL16 through the corresponding first via hole VIH1. The sixteenth wiring WL16 may be electrically connected to the fourth semiconductor pattern SCP4 of the ninth transistor T9 via the fifteenth wiring WL15.

The seventeenth wiring WL17 may extend in the second direction DR2, and be included in the sixth conductive layer CL6. The seventeenth wiring WL17 may be disposed apart from the sixteenth wiring WL16. The seventeenth wiring WL17 may be the k-th readout line RXk (hereinafter also referred to as a "readout line") described with reference to FIG. 5. The seventeenth wiring WL17 may be electrically connected to the sixth conductive pattern CP6 including the fifth conductive layer CL5 through the first via hole VIH1 which penetrates the seventh insulating layer INS7.

The sixth conductive pattern CP6 may include the fifth conductive layer CL5. One end of the sixth conductive pattern CP6 may be electrically connected to the seventeenth wiring WL17 (or the readout line) through the corresponding first via hole VIH1. An end opposite to the one end of the sixth conductive pattern CP6 may be electrically connected to the second semiconductor pattern SCP2 of the 10b-th transistor T10b through the first contact CNT1 which penetrates the sixth insulating layer INS6, the fifth insulating layer INS5, the fourth insulating layer INS4, the third insulating layer INS3, and the second insulating layer INS2.

The eighteenth wiring WL18 may extend in the second direction DR2, and be included in the seventh conductive layer CL7. The eighteenth wiring WL18 may be electrically connected to the sixteenth wiring WL16 through the second via hole VIH2 penetrating the eighth insulating layer INS8. In a plan viewed, the eighteenth wiring WL18 may overlap the sixteenth wiring WL16. In an embodiment, in the plan view, the eighteenth wiring WL18 may overlap an entirety of the sixteenth wiring WL16, for example, but is not limited thereto.

In embodiments, the fifteenth wiring WL15 may be the horizontal power wiring of the fourth power wiring PL4, and the sixteenth wiring WL16 may be the vertical power wiring of the fourth power wiring PL4. The eighteenth wiring WL18 may be electrically connected to the sixteenth wiring WL16 to configure the dummy pattern DMP of the fourth power wiring PL4. The fifteenth wiring WL15 which extends in the first direction DR1 and includes the fifth conductive layer CL5, the sixteenth wiring WL16 which extends in the second direction DR2 and is included in the sixth conductive layer CL6, and the eighteenth wiring WL18 which extends in the second direction DR2 and is included in the seventh conductive layer CL7 may be electrically connected to each other to form the fourth power wiring PL4 in a mesh structure. In other words, due to the fifteenth wiring WL15, the sixteenth wiring WL16, and the eighteenth wiring WL18 which are electrically connected, the fourth power wiring PL4 may have the mesh structure. As the sixteenth wiring WL16 included in the sixth conductive layer CL6 and the eighteenth wiring WL18 (or the dummy pattern DMP) included in the seventh conductive layer CL7 and overlapping the sixteenth wiring WL16 are electrically connected to each other, the vertical power wiring of the fourth power wiring PL4 may have a double-layer structure. Hence, the wiring resistance of the fourth power wiring PL4 may be reduced.

The second data line D2 may extend in the second direction DR2, and be included in the seventh conductive layer CL7. The second data line D2 may be disposed in the same layer as the eighteenth wiring WL18, and may be disposed apart from the eighteenth wiring WL18. The second data line D2 may correspond to the j-th data line Dj described with reference to FIG. 5 (or the second data line D2 described with reference to FIG. 9). The second data line D2 may be electrically connected to the first connection pattern CNP1 disposed within the second subpixel SPX2 through the second via hole VIH2 penetrating the eighth insulating layer INS8.

The third data line D3 may extend in the second direction DR2, and be included in the seventh conductive layer CL7. The third data line D3 may be disposed in the same layer as the eighteenth wiring WL18, and may be disposed apart from the eighteenth wiring WL18. The third data line D3 may be electrically connected to the first connection pattern CNP1 disposed within the third subpixel SPX3 through the second via hole VIH2 penetrating the eighth insulating layer INS8.

The first connection pattern CNP1 may be included in the sixth conductive layer CL6. One end of the first connection pattern CNP1 may be electrically connected to each of the second and third data lines D2, D3 through the corresponding second via hole VIH2. An opposite end of the first connection pattern CNP1 may be electrically connected to the third conductive pattern CP3 including the fifth conductive layer CL5 and disposed in each of the second and third subpixels SPX2, SPX3 through the first via hole VIH1 which penetrates the seventh insulating layer INS7.

The third conductive pattern CP3 may include the fifth conductive layer CL5. One end of the third conductive pattern CP3 may be electrically connected to the first connection pattern CNP1 through the corresponding first via hole VIH1. An end opposite to the one end of the third conductive pattern CP3 may be electrically connected to the first semiconductor pattern SCP1 of the second transistor T2 of each of the second and third pixel circuits PXC2, PXC3 through the first contact CNT1 which penetrates the sixth insulating layer INS6, the fifth insulating layer INS5, the fourth insulating layer INS4, the third insulating layer INS3, and the second insulating layer INS2.

In embodiments, in the second subpixel SPX2, the second data line D2 may be electrically connected to the first semiconductor pattern SCP1 of the second transistor T2 of the second pixel circuit PXC2 through the corresponding first connection pattern CNP1 and third conductive pattern CP3. In the third subpixel SPX3, the third data line D3 may be electrically connected to the first semiconductor pattern SCP1 of the second transistor T2 of the third pixel circuit PXC3 through the corresponding first connection pattern CNP1 and third conductive pattern CP3.

The first power wiring PL1 may extend in the second direction DR2, and be included in the sixth conductive layer CL6. The first power wiring PL1 may be disposed apart from the sixteenth and seventeenth wiring WL16, WL17. The first power voltage (refer to VDD of FIG. 5) may be supplied to the first power wiring PL1. The first power wiring PL1 may be electrically connected to the first conductive pattern CP1 of each of the second and third subpixels SPX2, SPX3 through the first via hole VIH1 which penetrates the seventh insulating layer INS7.

The first conductive pattern CP1 may include the fifth conductive layer CL5, and may be electrically connected to the first power wiring PL1 of each of the second and third subpixels SPX2, SPX3 through the corresponding first via hole VIH1. The first conductive pattern CP1 may be electrically connected to the first semiconductor pattern SCP1 of the fifth transistor T5 of each of the second and third pixel circuits PXC2, PXC3 through the corresponding first contact CNT1 which penetrates the sixth insulating layer INS6, the fifth insulating layer INS5, the fourth insulating layer INS4, the third insulating layer INS3, and the second insulating layer INS2. The first conductive pattern CP1 may be electrically connected to the upper electrode UE of the storage capacitor Cst included in the third conductive layer CL3 through the corresponding contact penetrating the sixth insulating layer INS6, the fifth insulating layer INS5, and the fourth insulating layer INS4.

A part of the first semiconductor pattern SCP1 of the fifth transistor T5 of each of the second and third pixel circuits PXC2, PXC3 may be electrically connected to the second conductive pattern CP2 including the fifth conductive layer CL5 through the first contact CNT1 which penetrates the second insulating layer INS2, the third insulating layer INS3, the fourth insulating layer INS4, the fifth insulating layer INS5, and the sixth insulating layer INS6. The second conductive pattern CP2 may correspond to the second pattern PT2 described with reference to FIG. 8.

The second pixel circuit PXC2 and the third pixel circuit PXC3 may have substantially similar or identical structures to the pixel circuit PXC described with reference to FIG. 8. Accordingly, a detailed description of the second and third pixel circuits PXC2, PXC3 is replaced by the description of FIG. 8.

The sensor circuit SC may be disposed between the second pixel circuit PXC2 and the third pixel circuit PXC3.

The sensor circuit SC may include the eighth transistor T8, the ninth transistor T9, and the tenth transistor T10.

The eighth transistor T8 may include an eighth active pattern ACT8 and an eighth gate electrode GE8. The eighth transistor T8 may be the first sensor transistor of the sensor circuit SC.

The eighth active pattern ACT8 may be an area of the second semiconductor pattern SCP2 overlapping with the eighth gate electrode GE8. The second semiconductor pattern SCP2 may include the first semiconductor layer SCL1. The second semiconductor pattern SCP2 may be disposed apart from the first semiconductor pattern SCP1 including the first semiconductor layer SCL1. The eighth active pattern ACT8 may be the channel area of the eighth transistor T8.

An area of the second semiconductor pattern SCP2 not overlapping with the eighth gate electrode GE8, and disposed on one side of the eighth active pattern ACT8 (e.g., a right side of the eighth active pattern ACT8 in the plan view) may be the first contact area. An area of the second semiconductor pattern SCP2 not overlapping with the eighth gate electrode GE8, and connected to an opposite side of the eighth active pattern ACT8 (e.g., a left side of the eighth active pattern ACT8 in the plan view) may be the second contact area. The first contact area may be connected to one side of the eighth active pattern ACT8, and may be electrically connected to the fifth conductive pattern CP5. The second contact area may be connected to each of an opposite side of the eighth active pattern ACT8 and the second semiconductor pattern SCP2 of the tenth transistor T10.

The eighth gate electrode GE8 may overlap with the eighth active pattern ACT8, and be included in the second conductive layer CL2. The eighth gate electrode GE8 may be an island-shaped conductive pattern. The eighth gate electrode GE8 may be disposed apart from the first gate electrode GE1 of the first transistor T1 of each of the second and third pixel circuits PXC2, PXC3. The eighth gate electrode GE8 may be electrically connected to the fourth conductive pattern CP4 through the first contact CNT1 which penetrates the sixth insulating layer INS6, the fifth insulating layer INS5, the fourth insulating layer INS4, the third insulating layer INS3, and the second insulating layer INS2.

The fourth conductive pattern CP4 may include the fifth conductive layer CL5. One end of the fourth conductive pattern CP4 may be electrically connected to the eighth gate electrode GE8 through the corresponding first contact CNT1. An opposite end of the fourth conductive pattern CP4 may be electrically connected to the fourth semiconductor pattern SCP4 of the ninth transistor T9 through the second contact CNT2 which penetrates the sixth insulating layer INS6 and the fifth insulating layer INS5. The fourth conductive pattern CP4 may be electrically connected to the second connection pattern CNP2 through the first via hole VIH1.

The second connection pattern CNP2 may be included in the sixth conductive layer CL6. The second connection pattern CNP2 may be electrically connected to the fourth conductive pattern CP4 through the corresponding first via hole VIH1 penetrating the seventh insulating layer INS7. The second connection pattern CNP2 may be electrically connected to the bridge pattern BRP through the second via hole VIH2.

The bridge pattern BRP may be included in the seventh conductive layer CL7. The bridge pattern BRP may be electrically connected to the second connection pattern CNP2 through the corresponding second via hole VIH2 penetrating the eighth insulating layer INS8. The bridge pattern BRP may be electrically connected to the eighth gate electrode GE8 of the eighth transistor T8 and the fourth semiconductor pattern SCP4 of the ninth transistor T9 through the second connection pattern CNP2 and the fourth conductive pattern CP4.

The bridge pattern BRP may be electrically connected to the first electrode (refer to EL1 of FIG. 6) of the light-receiving element (refer to LRD of FIG. 6) of the sensor circuit SC through the third via hole (refer to VIH3 of FIG. 6) penetrating the ninth insulating layer INS9. The bridge pattern BRP may be the second bridge pattern BRP2 described with reference to FIG. 6. In embodiments, the bridge pattern BRP is a connection member for electrically connecting the light-receiving element LRD, the eighth gate electrode GE8 of the eighth transistor T8, and the ninth transistor T9, and may be disposed at the fifth node N5 (or the gate node of the eighth transistor T8) described with reference to FIG. 5.

The ninth transistor T9 may include a ninth active pattern ACT9 and a ninth gate electrode.

The ninth active pattern ACT9 may be an area of the fourth semiconductor pattern SCP4 overlapping with the eleventh wiring WL11. The fourth semiconductor pattern SCP4 may include the second semiconductor layer SCL2. The fourth semiconductor pattern SCP4 may be disposed apart from the third semiconductor pattern SCP3 including the second semiconductor layer SCL2. The ninth active pattern ACT9 may be the channel area of the ninth transistor T9.

One area of the fourth semiconductor pattern SCP4 which does not overlap with the eleventh wiring WL11 and is connected to one side of the ninth active pattern ACT9 (e.g., an upper side of the ninth active pattern ACT9 in the plan view) may be the first contact area. One area of the fourth semiconductor pattern SCP4 which does not overlap with the eleventh wiring WL11 and is connected to an opposite side of the ninth active pattern ACT9 (e.g., a lower side of the ninth active pattern ACT9 in the plan view) may be the second contact area. The first contact area may be connected to one side of the ninth active pattern ACT9, and may be electrically connected to the fifteenth wiring WL15 through the second contact CNT2 penetrating the sixth insulating layer INS6 and the fifth insulating layer INS5. The second contact area may be connected to an opposite side of the ninth active pattern ACT9, and may be electrically connected to the eighth gate electrode GE8 of the eighth transistor T8 through the fourth conductive pattern CP4, for example.

The ninth gate electrode may be an area of the eleventh wiring WL11 overlapping with the ninth active pattern ACT9.

The tenth transistor T10 may have a dual-gate structure in which sub transistors are connected in series to prevent leakage current. In an embodiment, the tenth transistor T10 may include the 10a-th transistor T10a and the 10b-th transistor T10b, for example.

The 10a-th transistor T10a may include a 10a-th active pattern ACT10a and the 10a-th gate electrode.

The 10a-th active pattern ACT10a may be an area of the second semiconductor pattern SCP2 overlapping with the second wiring WL2. The second semiconductor pattern SCP2 may include the first semiconductor layer SCL1. The 10a-th active pattern ACT10a may be the channel area of the 10a-th transistor T10a.

One area of the second semiconductor pattern SCP2 which does not overlap with the second wiring WL2 and is connected to one side of the 10a-th active pattern ACT10a (e.g., an upper side of the 10a-th active pattern ACT10a in the plan view) may be the first contact area. One area of the second semiconductor pattern SCP2 which does not overlap with the second wiring WL2 and is connected to an opposite side of the 10a-th active pattern ACT10a (e.g., a lower side of the 10a-th active pattern ACT10a in the plan view) may be the second contact area. The first contact area may be connected to each of one side of the 10a-th active pattern ACT10a and the second semiconductor pattern SCP2 of the eighth transistor T8. The second contact area may be connected to each of an opposite side of the 10a-th active pattern ACT10a and the second semiconductor pattern SCP2 of the 10b-th transistor T10b.

The 10a-th gate electrode may be an area of the second wiring WL2 overlapping with the 10a-th active pattern ACT10a.

The 10b-th transistor T10b may include a 10b-th active pattern ACT10b and the 10b-th gate electrode.

The 10b-th active pattern ACT10b may be an area of the second semiconductor pattern SCP2 overlapping with the protrusion which protrudes in the second direction DR2 from the second wiring WL2 extending along the first direction DR1. The second semiconductor pattern SCP2 may include the first semiconductor layer SCL1. The 10b-th active pattern ACT10b may be the channel area of the 10b-th transistor T10b.

One area of the second semiconductor pattern SCP2 which does not overlap with the protrusion of the second wiring WL2 and is connected to one side of the 10b-th active pattern ACT10b (e.g., a left side of the 10b-th active pattern ACT10b in the plan view) may be the first contact area. One area of the second semiconductor pattern SCP2 which does not overlap with the protrusion of the second wiring WL2 and is connected to an opposite side of the 10b-th active pattern ACT10b (e.g., a right side of the 10b-th active pattern ACT10b in the plan view) may be the second contact area. The first contact area may be connected to each of one side of the 10b-th active pattern ACT10b and the second semiconductor pattern SCP2 of the 10a-th transistor T10a. The second contact area may be connected to an opposite side of the 10b-th active pattern ACT10b, and may be electrically connected to the seventeenth wiring WL17 (or the readout line) included in the sixth conductive layer CL6 through the sixth conductive pattern CP6.

In the above embodiment, the seventeenth wiring WL17 corresponding to the readout line may include a first part WL17a and a second part WL17b. In an embodiment, the seventeenth wiring WL17 may be divided into the first part WL17a corresponding to the bridge pattern BRP and the second part WL17b excluding the first part WL17a in the plan view, for example. In other words, the seventeenth wiring WL17 may include the first part WL17a next (adjacent) to the bridge pattern BRP and the second part WL17b not corresponding to the bridge pattern BRP in the plan view. In a plan viewed, a central part of the seventeenth wiring WL17 may be the first part WL17a, and an upper part and a lower part of the seventeenth wiring WL17 may be the second part WL17b respectively.

In a plan viewed, the first part WL17a of the seventeenth wiring WL17 may be disposed between the sixteenth wiring WL16 and the bridge pattern BRP. As the bridge pattern BRP is disposed between the first part WL17a of the seventeenth wiring WL17 and the third data line D3, a gap between the first part WL17a and the third data line D3 may be further secured. Hence, it is possible to reduce or prevent a coupling cap which may occur between the first part WL17a of the seventeenth wiring WL17 and the third data line D3. In the plan view, the second part WL17b of the seventeenth wiring WL17 may be disposed between the second data line D2 and the third data line D3.

In the plan view, the sixteenth wiring WL16 which is electrically connected to the eighteenth wiring WL18 (or the dummy pattern DMP) to have the double-layer structure may be disposed between the second data line D2 and the first part WL17a of the seventeenth wiring WL17. In other words, in the plan view, the fourth power wiring PL4 in the bi-layer structure which includes the sixteenth wiring WL16 included in the sixth conductive layer CL6 and the eighteenth wiring WL18 (or the dummy pattern DMP) included in the seventh conductive layer CL7 may be disposed between the second data line D2 and the first part WL17a of the seventeenth wiring WL17. As the sixteenth wiring WL16 and the eighteenth wiring WL18 (or the dummy pattern DMP) of the bi-layer structure supplied with the reset voltage VRST of the constant voltage level are disposed between the second data line D2 and the first part WL17a of the seventeenth wiring WL17, the coupling cap which may occur between the first part WL17a of the seventeenth wiring WL17 and the second data line D2 may be reduced or prevented.

In the plan view, the second part WL17b of the seventeenth wiring WL17 may be positioned relatively adjacent to the third data line D3 compared to the first part WL17a. In other words, in the plan view, the gap between the second part WL17b of the seventeenth wiring WL17 and the third data line D3 may be smaller (or narrower) than the gap between the first part WL17a of the seventeenth wiring WL17 and the third data line D3. In the plan view, the second part WL17b of the seventeenth wiring WL17 may overlap with the eighteenth wiring WL18 included in the seventh conductive layer CL7. The eighteenth wiring WL18 may be the dummy pattern DMP electrically connected to the sixteenth wiring WL16 to which the reset voltage VRST is applied. As the eighteenth wiring WL18 to which the reset voltage VRST is supplied is disposed on the second part WL17b of the seventeenth wiring WL17, the coupling cap which may occur between the second part WL17b of the seventeenth wiring WL17 and the third data line D3 may be reduced or prevented. In other words, the eighteenth wiring WL18 (or the dummy pattern DMP) may be utilized as a shielding member for reducing or preventing the coupling cap which may occur between the second part WL17b of the seventeenth wiring WL17 which is the readout line and the third data line D3.

When the eighteenth wiring WL18 (or the dummy pattern DMP) is utilized as the shielding member, it is possible to reduce or prevent a phenomenon in which a signal (e.g., a data signal) applied to the third data line D3 is affected by the sensing signal transmitted to the seventeenth wiring WL17 (or the readout line). Thus, noise generated in the sensing signal applied to the seventeenth wiring WL17 may be reduced by the signal applied to the third data line D3. Hence, fingerprint sensitivity and fingerprint sensing accuracy at the first light-sensing pixel PSR1 may be improved to further improve the reliability of the display device (refer to 1 of FIG. 1).

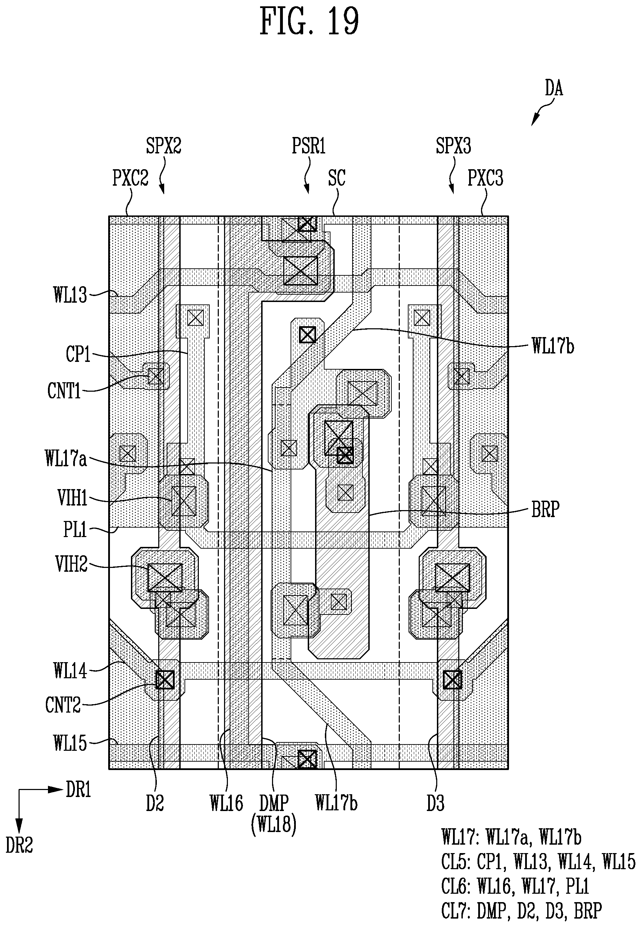

FIG. 19 is a schematic plan view illustrating an embodiment of subpixels SPX and a first light-sensing pixel PSR1 disposed in one area of a display area DA of a display device 1. Particularly, FIG. 19 shows a modification embodiment of FIG. 17 in relation to the shape of the dummy pattern DMP.

For ease of explanation, FIG. 19 illustrates only the configurations included in the fifth conductive layer CL5, the sixth conductive layer CL6, and the seventh conductive layer CL7 in the second and third subpixels SPX2, SPX3 and the first light-sensing pixel PSR1 arranged in the same pixel row.

In FIG. 19, differences from the aforementioned embodiment are mainly described to avoid redundant explanation.

Referring to FIG. 19, the dummy pattern DMP may not overlap with the seventeenth wiring WL17. In an embodiment, the dummy pattern DMP may not overlap with the first part WL17a and the second part WL17b of the seventeenth wiring WL17, for example. The dummy pattern DMP may be included in the seventh conductive layer CL7, and may be the eighteenth wiring WL18 electrically connected to the sixteenth wiring WL16.

Even when the seventeenth wiring WL17 corresponding to the readout line does not overlap the dummy pattern DMP (or the eighteenth wiring WL18), as the sixteenth wiring WL16 and the dummy pattern DMP electrically connected to have the bi-layer structure are disposed between the second data line D2 and the seventeenth wiring WL17 in the plan view, the coupling cap which may occur between the second data line D2 and the seventeenth wiring WL17 may be reduced or prevented.

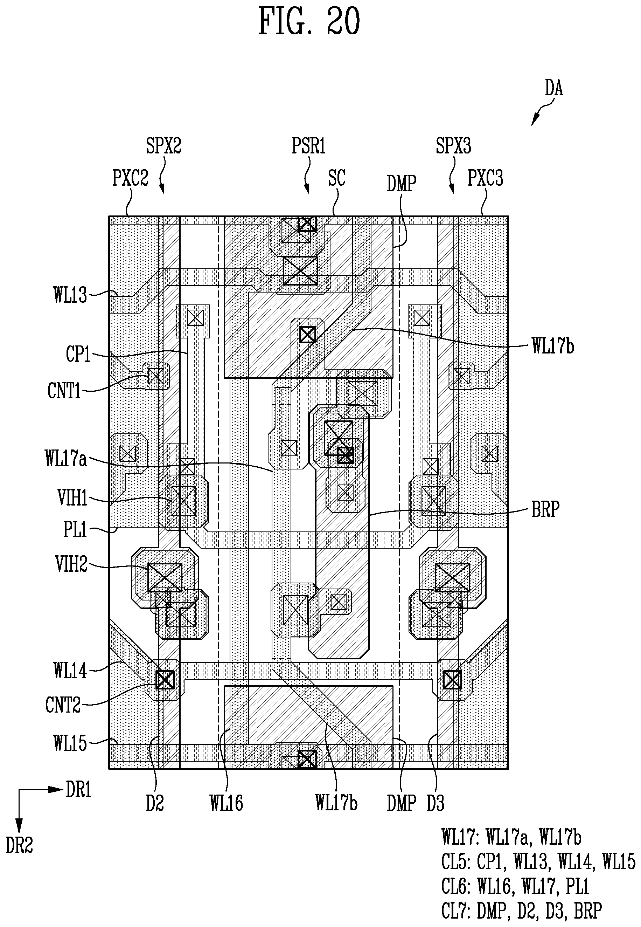

FIG. 20 is a schematic plan view illustrating an embodiment of subpixels SPX and a first light-sensing pixel PSR1 disposed in one area of a display area DA of a display device. In particular, FIG. 20 shows a modification embodiment of FIG. 17 in relation to the shape of the dummy pattern DMP.

For ease of explanation, FIG. 20 illustrates only the configurations included in the fifth conductive layer CL5, the sixth conductive layer CL6, and the seventh conductive layer CL7 in the second and third subpixels SPX2, SPX3 and the first light-sensing pixel PSR1 arranged in the same pixel row.

In FIG. 20, differences from the above embodiment are mainly described to avoid redundant explanation.

Referring to FIG. 20, the seventeenth wiring WL17 may include a first part WL17a and a second part WL17b. The second part WL17b of the seventeenth wiring WL17a may overlap with the dummy pattern DMP. The dummy pattern DMP may be included in the seventh conductive layer CL7, and may be the eighteenth wiring WL18 electrically connected to the sixteenth wiring WL16 included in the sixth conductive layer CL6 through the corresponding second via hole VIH2.

The dummy pattern DMP may overlap with at least a part of the seventeenth wiring WL17. In an embodiment, the dummy pattern DMP may not overlap with one area of the sixteenth wiring WL16 next (adjacent) to the first part WL17a of the seventeenth wiring WL17, and may overlap with one area of the sixteenth wiring WL16 next (adjacent) to the second part WL17b of the seventeenth wiring WL17, for example. The dummy pattern DMP may be electrically connected to other one area of the sixteenth wiring WL16 through the corresponding second via hole VIH2 to implement the bi-layer structure with the sixteenth wiring WL16.

In a plan viewed, one area of the sixteenth wiring WL16 not overlapping with the dummy pattern DMP may be disposed between the second data line D2 and the first part WL17a of the seventeenth wiring WL17, and other one area of the sixteenth wiring WL16 overlapping with the dummy pattern DMP and electrically connected to the dummy pattern DMP to form the bi-layer structure therewith may be disposed between the second data line D2 and the third data line D3.

As described above, as the dummy pattern DMP included in the seventh conductive layer CL7 is disposed on the second part WL17b of the seventeenth wiring WL17 included in the sixth conductive layer CL6 and overlaps with the second part WL17b of the seventeenth wiring WL17, it is possible to reduce or prevent a coupling cap which may occur between the second part WL17b of the seventeenth wiring WL17 and the third data line D3.

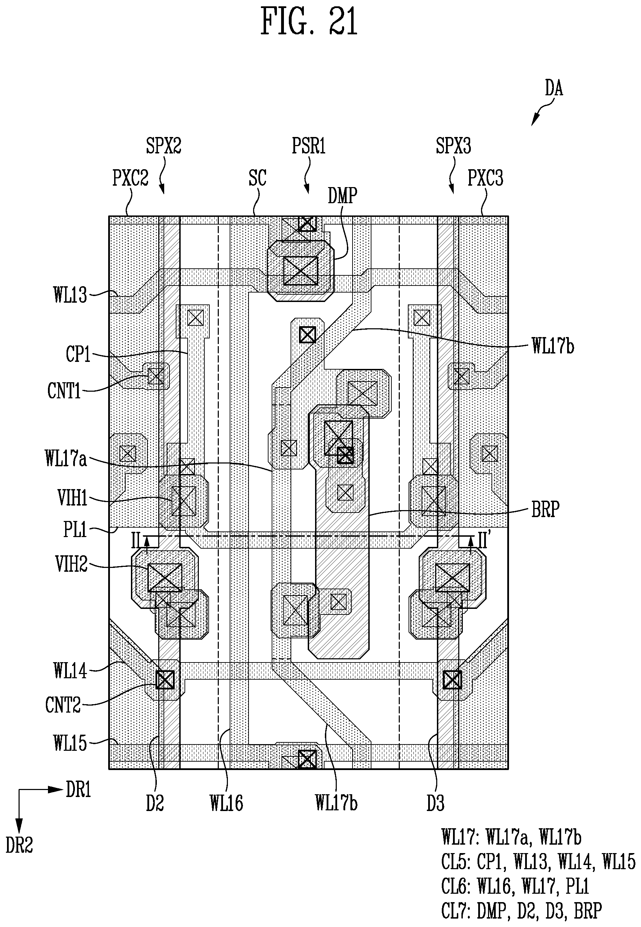

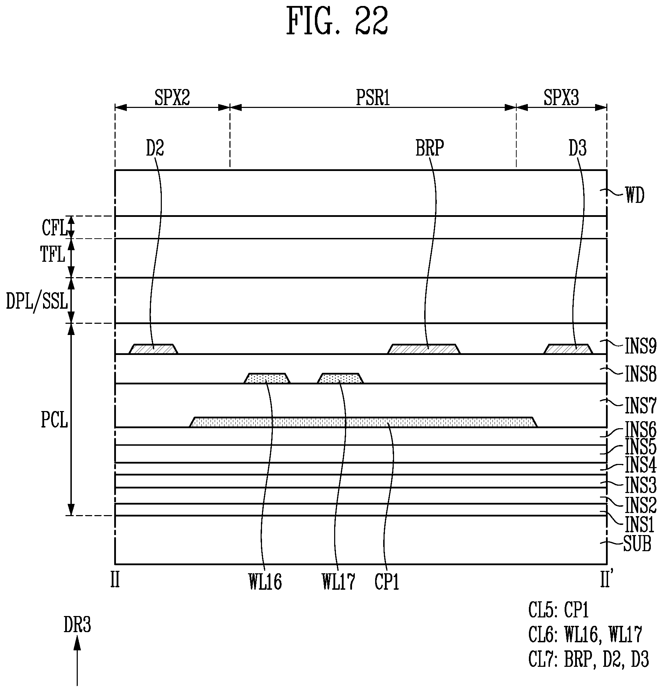

FIG. 21 is a schematic plan view illustrating an embodiment of subpixels SPX and a first light-sensing pixel PSR1 disposed in one area of a display area DA of a display device, and FIG. 22 is a schematic cross-sectional diagram along line II-II' of FIG. 21. In particular, FIG. 21 shows a modification embodiment of FIG. 17 in relation to the shape of the dummy pattern DMP.

For the convenience of explanation, FIG. 21 illustrates only the configurations included in the fifth conductive layer CL5, the sixth conductive layer CL6, and the seventh conductive layer CL7 in the second and third subpixels SPX2, SPX3 and the first light-sensing pixel PSR1 arranged in the same pixel row.

In FIG. 21 and FIG. 22, differences from the above embodiment are mainly described to avoid redundant explanation.

Referring to FIG. 21 and FIG. 22, the dummy pattern DMP may be included in the seventh conductive layer CL7. The dummy pattern DMP may be an island-shaped conductive pattern. The dummy pattern DMP may overlap at least a part of the sixteenth wiring WL16 in the plan view. The dummy pattern DMP may be electrically connected to the sixteenth wiring WL16 included in the sixth conductive layer CL6 through the corresponding second via hole VIH2. The dummy pattern DMP may be electrically connected to the sixteenth wiring WL16 supplied with the reset voltage (refer to VRST of FIG. 7) to implement the bi-layer structure with a part of the sixteenth wiring WL16, thus reducing the wiring resistance of the sixteenth wiring WL16.

In a plan viewed, the dummy pattern DMP and the sixteenth wiring WL16 electrically connected may be disposed between the second data line D2 and the seventeenth wiring WL17 (or the readout line).

In embodiments, the dummy pattern DMP may not overlap with the seventeenth wiring WL17. Even when the dummy pattern DMP does not overlap with the seventeenth wiring WL17, as the bridge pattern BRP included in the seventh conductive layer CL7 is disposed between the first part WL17a of the seventeenth wiring WL17 and the third data line D3, a separation distance between the first part WL17a of the seventeenth wiring WL17 and the third data line D3 may be further obtained. Hence, the coupling cap which may occur between the first part WL17a of the seventeenth wiring WL17 and the third data line D3 may be reduced or prevented.

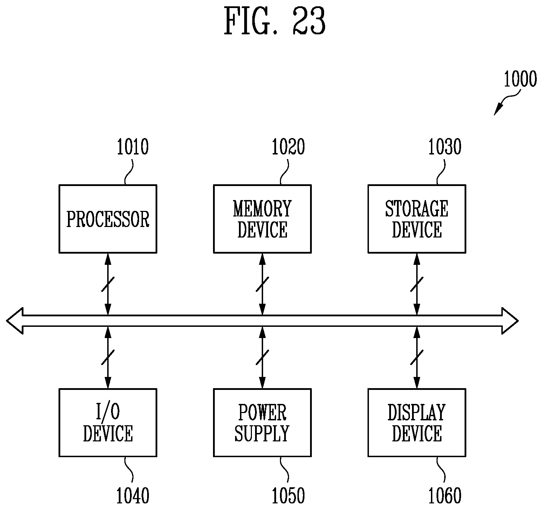

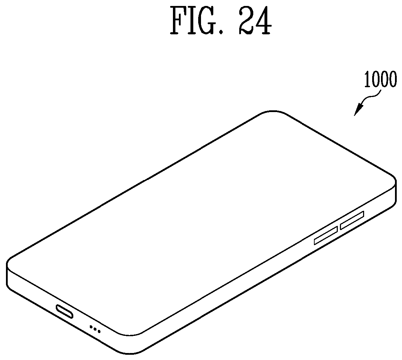

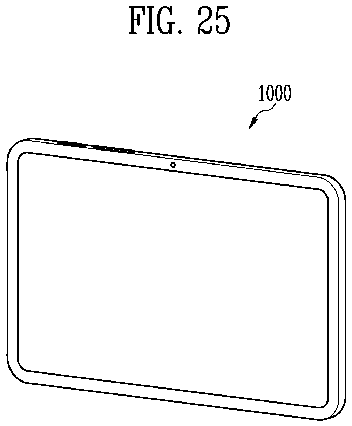

FIG. 23 is a schematic block diagram illustrating an embodiment of an electronic device 1000, FIG. 24 is a schematic diagram illustrating an embodiment of the electronic device 1000 of FIG. 23 implemented with a smartphone, and FIG. 25 is a schematic diagram illustrating an embodiment of the electronic device 1000 of FIG. 23 implemented with a tablet personal computer ("PC").

Referring to FIG. 23 through FIG. 25, the electronic device 1000 may include a processor (or processing circuit) 1010, a memory device 1020, a storage device 1030, an input/output ("I/O") device 1040, a power supply 1050, and a display device 1060. In this case, the display device 1060 may be the display device 1 of FIG. 1 and FIG. 2. The electronic device 1000 may further include several ports for communicating with a video card, a sound card, a memory card, a universal serial bus ("USB") and so on device, or for communicating with other systems. In embodiments, as shown in FIG. 24, the electronic device 1000 may be implemented as the smartphone. In another embodiment, the electronic device 1000 may be implemented as the tablet PC, as shown in FIG. 25. However, this is illustrative, and the electronic device 1000 is not limited to the above-described example. In an embodiment, the electronic device 1000 may be implemented as a mobile phone, a video phone, a smart pad, a smart watch, car navigation, a computer monitor, a laptop, a head-mounted display device, or the like, for example.

The processor 1010 may perform predetermined calculations or tasks. In embodiments, the processor 1010 may be a microprocessor, a central processing unit, an application processor, and so on. The processor 1010 may be connected to other components via an address bus, a control bus and a data bus. In embodiments, the processor 1010 may be connected to an expansion bus such as a peripheral component interconnect ("PCI") bus.

The memory device 1020 may store desired data for the operation of the electronic device 1000. In an embodiment, the memory device 1020 may include a non-volatile memory device such as an erasable programmable read-only memory ("EPROM") device, an electrically erasable programmable read-only memory ("EEPROM") device, a flash memory device, a phase change random access memory ("PRAM") device, a resistance random access memory ("RRAM") device, a nano floating gate memory ("NFGM") device, a polymer random access memory ("PoRAM") device, a magnetic random access memory ("MRAM"), or a ferroelectric random access memory ("EFRAM") device and/or a volatile memory device such as a dynamic random access memory ("DRAM") device, a static random access memory ("SRAM") device, or a mobile DRAM device, for example.

The storage device 1030 may include a solid state drive ("SSD"), a hard disk drive ("HDD"), a compact disk read-only memory ("CD-ROM") and so on.

The I/O device 1040 may include input means such as a keyboard, a keypad, a touchpad, a touchscreen, or a mouse, and output means such as a speaker, or a printer. In embodiments, the display device 1060 may be included in the I/O device 1040.

The power supply 1050 may supply the power desired for the operation of the electronic device 1000. In an embodiment, the power supply 1050 may be a power management integrated circuit ("PMIC"), for example.

The display device 1060 may display an image corresponding to visual information of the electronic device 1000. At this time, the display device 1060 may be, but not limited to, an organic light-emitting display device or a quantum dot light-emitting display. The display device 1060 may be connected to other components via the buses or other communication links.

Embodiments can provide a display device comprising: a first subpixel, a second subpixel, and a third subpixel arranged in a first direction; a light-sensing pixel disposed between the second subpixel and the third subpixel; the light-sensing pixel comprising: a sensor circuit; a readout line extending along a second direction, and electrically connected to the light-sensing pixel; a first data line extending along the second direction, and electrically connected to the second subpixel; a second data line extending along the second direction, and electrically connected to the third subpixel; a dummy pattern disposed between the first data line and the second data line; and a reset voltage wiring electrically connected to the light-sensing pixel and supplied with a reset voltage, wherein the readout line is disposed in a different layer from the first and second data lines, and wherein the readout line is disposed in a same layer as the reset voltage wiring.

The first data line, the second data line, and the dummy pattern may be disposed in a same layer, and the first data line, the second data line, and the dummy pattern are disposed on the readout line and the reset voltage wiring with an insulating layer interposed therebetween.

The reset voltage wiring may overlap with the dummy pattern, and may be electrically connected to the dummy pattern, and form a bi-layer structure.

The reset voltage wiring may be connected to a reset voltage supply in the display device.

Embodiments can provide a display device comprising: a first subpixel, a second subpixel, and a third subpixel arranged in a first direction; a light-sensing pixel disposed between the second subpixel and the third subpixel, the light-sensing pixel comprising: a sensor circuit; a readout line extending along a second direction, and electrically connected to the light-sensing pixel; a first data line extending along the second direction, and electrically connected to the second subpixel; a second data line extending along the second direction, and electrically connected to the third subpixel; a dummy pattern disposed between the first data line and the second data line; and a reset voltage wiring electrically connected to the light-sensing pixel and supplied with a reset voltage, wherein the readout line and the reset voltage wiring are disposed in a same layer, the first data line, the second data line, and the dummy pattern are disposed in a same layer, the first data line, the second data line, and the dummy pattern are disposed on the readout line and the reset voltage wiring with an insulating layer interposed therebetween, and the reset voltage wiring overlaps with the dummy pattern, is electrically connected to the dummy pattern, and forms a bi-layer structure.

Embodiments can provide an electronic device comprising: a processor which provides input image data to a display device; and the display device which displays an image based on the input image data, the display device being according to any of the above-mentioned embodiments.

Although the invention has been described with reference to preferred embodiments above, a person skilled in the art or a person with a general knowledge of the technical field will appreciate that the invention may be modified and changed in various ways without departing from the technical scope of the invention as set forth in the appended claims.

Therefore, the technical scope of the disclosure should not be limited to what is described in the detailed description of the specification but should be defined by the appended claims.

## Claims

1. A display device comprising:
a first subpixel, a second subpixel, and a third subpixel arranged in a first direction;
a light-sensing pixel disposed between the second subpixel and the third subpixel; the light-sensing pixel comprising:
a sensor circuit;
a readout line extending along a second direction, and electrically connected to the light-sensing pixel;
a first data line extending along the second direction, and electrically connected to the second subpixel;
a second data line extending along the second direction, and electrically connected to the third subpixel;
a dummy pattern disposed between the first data line and the second data line; and
a reset voltage wiring electrically connected to the light-sensing pixel and supplied with a reset voltage,
wherein the readout line is disposed in a different layer from the first and second data lines, and
wherein the readout line is disposed in a same layer as the reset voltage wiring.

2. The display device according to claim 1, wherein the dummy pattern is disposed in a same layer as the first and second data lines, and
wherein the dummy pattern, the first data line, and the second data line are disposed on the readout line and the reset voltage wiring with an insulating layer interposed between a layer at which the dummy pattern, the first data line, and the second data line are located and a layer at which the readout line and the reset voltage wiring are located.

3. The display device according to claim 2, wherein the dummy pattern overlaps with the reset voltage wiring, and is electrically connected to the reset voltage wiring.

4. The display device according to claim 3, wherein the dummy pattern and the reset voltage wiring are disposed between the first data line and the readout line, in a plan view.

5. The display device according to claim 4, wherein the sensor circuit comprises:
a light-receiving element;
a first sensor transistor arranged to control current flowing to the readout line in response to a voltage of one electrode of the light-receiving element;
a second sensor transistor electrically connected between the first sensor transistor and the readout line; and
a third sensor transistor electrically connected between the reset voltage wiring and the one electrode of the light-receiving element and including a gate electrode connected to a reset line,
the first and second sensor transistors comprise a first type semiconductor, and
the third sensor transistor comprises a second type semiconductor which is different from the first type semiconductor.

6. The display device according to claim 5, further comprising:
a bridge pattern electrically connecting a gate electrode of the first sensor transistor and the one electrode of the light-receiving element, and
wherein the bridge pattern is disposed in the same layer as the first and second data lines.

7. The display device according to claim 6, wherein the readout line comprises a first part next to the bridge pattern in the first direction and a second part excluding the first part, in the plan view,
wherein the first part of the readout line is disposed between the first data line and the bridge pattern, in the plan view, and
wherein the second part of the readout line is disposed between the first data line and the second data line, in the plan view;
optionally wherein the dummy pattern does not overlap with the first part of the readout line; or wherein the dummy pattern overlaps with the second part of the readout line; or wherein the dummy pattern does not overlap with the first and second parts of the readout line.

8. The display device according to claim 7, wherein the readout line is disposed between the reset voltage wiring and the second data line, in the plan view;
optionally wherein the bridge pattern is disposed between the first part of the readout line and the second data line, in the plan view.

9. The display device according to any one of claims 1 to 8, wherein the dummy pattern overlaps with at least a part of the reset voltage wiring.

10. The display device according to any one of claims 1 to 9, comprising:
a substrate;
first, second, third, fourth, fifth, sixth, seventh, eighth, and ninth insulating layers sequentially disposed on the substrate;
a first conductive layer disposed between the substrate and the first insulating layer;
a second conductive layer disposed between the second insulating layer and the third insulating layer;
a third conductive layer disposed between the third insulating layer and the fourth insulating layer;
a fourth conductive layer disposed between the fifth insulating layer and the sixth insulating layer;
a fifth conductive layer disposed between the sixth insulating layer and the seventh insulating layer;
a sixth conductive layer disposed between the seventh insulating layer and the eighth insulating layer; and
a seventh conductive layer disposed between the eighth insulating layer and the ninth insulating layer,
wherein the sixth conductive layer comprises the readout line and the reset voltage wiring, and
wherein the seventh conductive layer comprises the first data line, the second data line, and the dummy pattern.

11. The display device according to any one of claims 1 to 10, wherein each of the first subpixel, the second subpixel, and the third subpixel comprises a light-emitting element for emitting light and at least one transistor electrically connected to the light-emitting element.

12. A display device comprising:
a first subpixel, a second subpixel, and a third subpixel arranged in a first direction;
a light-sensing pixel disposed between the second subpixel and the third subpixel, the light-sensing pixel comprising:
a sensor circuit;
a readout line extending along a second direction, and electrically connected to the light-sensing pixel;
a first data line extending along the second direction, and electrically connected to the second subpixel;
a second data line extending along the second direction, and electrically connected to the third subpixel;
a dummy pattern disposed between the first data line and the second data line; and
a reset voltage wiring electrically connected to the light-sensing pixel and supplied with a reset voltage,
wherein the readout line and the reset voltage wiring are disposed in a same layer,
wherein the first data line, the second data line, and the dummy pattern are disposed in a same layer,
wherein the first data line, the second data line, and the dummy pattern are disposed on the readout line and the reset voltage wiring with an insulating layer interposed between a layer at which the first data line, the second data line, and the dummy pattern are located and a layer at which the readout line and the reset voltage wiring are located, and
wherein the reset voltage wiring overlaps with the dummy pattern, is electrically connected to the dummy pattern, and the reset voltage wiring and the dummy pattern overlapped with each other form a bi-layer structure.

13. The display device according to claim 12, wherein the reset voltage wiring and the dummy pattern overlapping each other are disposed between the first data line and a part of the readout line, in a plan view.

14. The display device according to claim 12 or 13, further comprising:
a bridge pattern electrically connected to a gate electrode of a first sensor transistor of the sensor circuit,
wherein the bridge pattern is disposed in the same layer as the first data line, the second data line, and the dummy pattern,
wherein the readout line comprises a first part next to the bridge pattern in the first direction and a second part excluding the first part, in a plan view, and
wherein the dummy pattern does not overlap with the first part of the readout line, and overlaps with the second part of the readout line.

15. An electronic device comprising:
a processor which provides input image data to a display device; and
the display device which displays an image based on the input image data, the display device is according to any one of claim 1 to 14.
